# FASCICULE DE BREVET EUROPEEN

(11) **EP 2 743 659 B1**
(45) Date de publication et mention de la délivrance du brevet: **31.07.2024**
(21) Numéro de dépôt: 13197327.3
(22) Date de dépôt: 16.12.2013
(51) Int. Cl.: G01J 5/20

(54) **Procédé de réalisation d'un dispositif de détection infrarouge**
Verfahren zur Umsetzung einer Infraroterfassungsvorrichtung
Method for manufacturing an infrared detection device

(30) Priorité: 17.12.2012 FR 1262153
(43) Date de publication de la demande: 18.06.2014
(73) Titulaire: Commissariat à l'Énergie Atomique et aux Énergies Alternatives, 75015 Paris (FR)
(72) Inventeur: Yon, Jean-Jacques, 38360 Sassenage (FR); Dumont, Geoffroy, 75011 Paris (FR); Imperinetti, Pierre, 38180 Seyssins (FR); Pocas, Stéphane, 38000 Grenoble (FR)
(74) Mandataire: Brevalex

(56) Documents cités:
- EP-A2- 1 243 903
- WO-A1-2012/015965
- DE-A1- 10 058 864
- US-A1- 2008 237 469
- US-A1- 2012 213 245
- ADRIANA LAPADATU ET AL: "High-performance long wave infrared bolometer fabricated by wafer bonding", PROCEEDINGS OF SPIE, S P I E - INTERNATIONAL SOCIETY FOR OPTICAL ENGINEERING, US, vol. 7660, 5 April 2010 (2010-04-05), pages 766016 - 1, XP007921961, ISSN: 0277-786X

## Description

### DOMAINE TECHNIQUE ET ART ANTÉRIEUR

La présente invention concerne un procédé de réalisation d'un dispositif de détection infrarouge, comportant au moins un détecteur thermique de rayonnement infrarouge pouvant fonctionner à température ambiante, par exemple de type micro-bolomètre, ainsi qu'un tel dispositif de détection infrarouge. Le dispositif de détection obtenu par le procédé selon l'invention peut notamment être utilisé dans les domaines de l'imagerie infrarouge, de la thermographie, de la gestion d'automatismes par exemple dans des bâtiments, ou encore de la détection de gaz via une mesure d'absorption dans un spectre infrarouge apte à être détecté par le détecteur thermique infrarouge.

Un dispositif de détection infrarouge comporte généralement une pluralité de détecteurs unitaires de rayonnement infrarouge, formant chacun un pixel du dispositif de détection, reliés à un circuit électronique de lecture chargé d'opérer et d'exploiter les signaux délivrés par les pixels. Chacun de ces détecteurs thermiques infrarouges, ou pixels, comporte une membrane absorbante suspendue par des moyens de support thermiquement isolants au-dessus d'un substrat de semi-conducteur (par exemple du silicium) comportant le circuit électronique de lecture utilisé pour le traitement des signaux délivrés par les détecteurs thermiques infrarouges.

Les détecteurs thermiques infrarouges peuvent être réalisés par des procédés microélectroniques collectifs, c'est-à-dire tous réalisés simultanément, pour l'ensemble de la plaquette, ou substrat ou wafer, de semi-conducteur. Ces procédés collectifs permettent la réalisation de matrices de détecteurs thermiques infrarouges de grande complexité, comportant un grand nombre de pixels (par exemple sous la forme de matrices de 640 × 480 pixels), et également la réalisation d'un grand nombre de matrices par plaquette.

Les techniques de la microélectronique permettent par ailleurs d'intégrer, sur la plaquette, des circuits électroniques de lecture de type VLSI (« Very Large Scale intégration », ou intégration à très grande échelle) aptes à lire une matrice de pixels. Le circuit électronique de lecture est généralement intégré en technologie CMOS et comporte dans ce cas des couches profondes à base de semi-conducteur où sont implantés des dispositifs électroniques comprenant notamment des transistors et des diodes (partie « Front End » du circuit électronique de lecture) et des couches superficielles où sont prévus plusieurs niveaux d'interconnexions électriques (partie « Back End » du circuit électronique de lecture) pour relier notamment les dispositifs électroniques entre eux.

Un traitement adéquat des signaux délivrés par un grand nombre de pixels peut être obtenu en réalisant au moins autant de liens électriques que de pixels entre ces pixels et le circuit de lecture. Ces liens électriques sont donc eux aussi réalisés de manière collective, selon différentes options techniques qui dépendent de l'architecture choisie pour réaliser le dispositif de détection infrarouge, à savoir la matrice de détecteurs thermiques infrarouges couplée à son circuit de lecture.

Selon une première architecture (appelée « above IC », ou au-dessus du circuit intégré), la matrice de détecteurs thermiques infrarouges est fabriquée au-dessus du circuit de lecture réalisé au préalable sur un substrat de silicium. La matrice de détecteurs est réalisée selon une technique dite de micro-usinage de surface qui consiste à construire les détecteurs thermiques infrarouges à la surface d'une couche sacrificielle placée entre la surface du circuit de lecture et la face inférieure des détecteurs. Des liens électriques sont réalisés à travers l'épaisseur de la couche sacrificielle de manière à connecter les terminaux électriques des détecteurs aux points d'entrée du circuit de lecture. Cette couche sacrificielle est éliminée en fin de processus de fabrication pour aboutir aux membranes suspendues souhaitées et obtenir en conséquence leur isolation thermique vis-à-vis du substrat. Cette suppression de la couche sacrificielle qui repose sur la surface du circuit de lecture déjà achevé nécessite toutefois que le procédé utilisé élimine la couche sacrificielle sans endommager les couches superficielles du circuit de lecture. Il en résulte une contrainte forte sur la nature de la couche sacrificielle qui est réalisée à base d'un matériau organique, par exemple en polyimide, qui peut être gravé avec une très grande sélectivité vis-à-vis des couches minérales du circuit de lecture. Le document US 5 912 464 décrit un procédé de réalisation d'une telle architecture.

Ce premier type d'architecture présente toutefois l'inconvénient de devoir faire appel à un matériau organique pour la réalisation des détecteurs thermiques infrarouges, ce qui sort des techniques standards de la microélectronique et restreint les moyens et les procédés utilisables pour la réalisation de ces détecteurs. C'est notamment le cas des moyens de nettoyage par plasma des résines photosensibles qui ne peuvent pas être utilisés en raison de leur action agressive et indésirable sur le polyimide. Il en résulte donc un procédé de fabrication spécifique, et donc coûteux.

Selon une deuxième architecture faisant appel à une technique appelée « micro-usinage de volume », la matrice de détecteurs est fabriquée simultanément et avec les mêmes couches profondes de la technologie CMOS que celles utilisées pour réaliser les dispositifs électroniques du circuit de lecture. Le document de D. Takamuro et al., « Development of new SOI diode structure for beyond 17µm pixel pitch SOI diode uncooled IRFPAs », Proc. SPIE, Vol. 8012 (2011) décrit un exemple d'une telle structure où chaque détecteur thermique infrarouge de la matrice est composé de plusieurs jonctions PN en silicium, connectées en série et polarisées dans leur régime direct. Selon cette architecture, les détecteurs thermiques infrarouges et les dispositifs électroniques du circuit de lecture sont intégrés dans un même plan situé dans les couches profondes, en technologie CMOS. Les détecteurs thermiques infrarouges et le circuit de lecture sont juxtaposés et se partagent la surface disponible sur le substrat de silicium. Les liens électriques entre les détecteurs thermiques et le circuit de lecture sont horizontaux et sont réalisés en utilisant au moins une partie des couches de la technologie CMOS. Le caractère suspendu et l'isolation thermique sont obtenus par une gravure localisée du silicium sous lesdites jonctions PN des détecteurs thermiques. La propagation de la gravure du silicium dans un plan parallèle à la surface du substrat est contrôlée par des tranchées essentiellement verticales qui isolent les zones de silicium prévues pour intégrer les détecteurs de celles utilisées pour le circuit de lecture. La propagation de la gravure dans une direction perpendiculaire au plan du substrat est quant à elle déterminée par la durée du procédé de gravure.

Bien que ce type d'architecture évite l'utilisation d'une couche sacrificielle organique, un premier inconvénient de cette deuxième architecture est qu'elle exige la réalisation de tranchées profondes pour stopper la gravure latérale du semi-conducteur, ce qui grève le coût de fabrication du dispositif. Un deuxième inconvénient résulte du rapport de la surface utilisée pour réaliser les détecteurs thermiques infrarouges par rapport à la surface totale disponible pour les pixels, autrement appelé facteur de remplissage qui est plus faible que celui pour une architecture superposée « above IC ». Il s'ensuit qu'une partie du rayonnement infrarouge qui illumine les pixels n'est pas capturée par les détecteurs, la performance de détection s'en trouvant diminuée d'autant. Pour palier à ce deuxième inconvénient, le document de D. Takamuro et al. précédemment cité prévoit l'ajout de structures absorbantes, suspendues et recouvrant l'essentiel de la surface du pixel. Toutefois, outre l'accroissement de complexité, cet ajout introduit d'une part une inertie thermique supplémentaire et appelle d'autre part un procédé de fabrication par micro-usinage de surface qui présente les mêmes inconvénients que ceux déjà évoqués pour l'architecture précédente, notamment l'utilisation d'un matériau sacrificiel organique. Enfin, un troisième inconvénient correspond à la surface moindre consacrée aux dispositifs électroniques du circuit de lecture qui limite les capacités de traitement de signaux du circuit de lecture, tout particulièrement lorsqu'il s'agit d'intégrer des fonctions électroniques au sein des pixels.

Selon une troisième architecture, dite hybride, le dispositif de détection infrarouge est obtenu par l'assemblage de deux substrats. Le premier substrat comporte des circuits de lecture déjà réalisés sous la forme de circuits intégrés sur le premier substrat. Le deuxième substrat comporte des matrices de détecteurs thermiques infrarouges prévues pour être chacune reliée à un circuit de lecture du premier substrat. L'assemblage des deux substrats peut être réalisé par une interconnexion flip-chip, par exemple sous la forme d'un assemblage par soudure de billes métalliques. Une autre option est d'assembler les deux substrats par un collage direct (direct bonding).

L'avantage apporté par une architecture hybride est de pouvoir élaborer des matrices de détecteurs thermiques infrarouges sur un substrat séparé et indépendant du substrat CMOS qui comporte des circuits de lecture. Cette indépendance permet d'utiliser notamment des procédés mis en oeuvre à haute température qui sont de nature à améliorer la qualité des détecteurs thermiques mais qui ne peuvent pas être utilisés avec les deux architectures précédentes car ils conduiraient à une détérioration du substrat CMOS en raison des températures mises en jeu qui peuvent être supérieure à environ 400°C.

Le document de A. Lapadatu et al., « High performance long wave infrared bolometer fabricated by wafer bonding », Proc. SPIE, Vol. 7660 (2010), décrit deux exemples d'assemblage hybride permettant de connecter un premier substrat comprenant des circuits de lecture déjà achevés avec un deuxième substrat comprenant des détecteurs thermiques infrarouges constitués de thermistors à multi-puits quantiques Si/SiGe. Dans un premier exemple d'assemblage, la surface de chacun des deux substrats est recouverte de SiO₂ puis ils sont assemblés par collage à basse température, oxyde contre oxyde. Les liens électriques entre détecteurs et circuits de lecture sont réalisés a postériori en réalisant un contact électrique à travers toute l'épaisseur du détecteur et toute l'épaisseur des deux couches de SiO₂, en relation avec des dispositifs réceptacles disposés sur le substrat des circuits de lecture et réalisés préalablement au collage. Dans un deuxième exemple, des liens électriques en cuivre sont prévus à la surface de chacun des deux substrats qui sont ensuite assemblés par thermo-compression cuivre contre cuivre. Pour améliorer la robustesse mécanique de l'assemblage, les liens électriques en cuivre sont intégrés dans une couche d'oxyde de laquelle ils affleurent. On obtient ainsi un collage hybride, essentiellement oxyde contre oxyde, et localement cuivre contre cuivre au niveau des liens électriques. Pour chacun des deux exemples d'assemblage, le caractère suspendu et l'isolation thermique des détecteurs sont obtenus par une attaque acide en milieu HF vapeur qui grave sélectivement les couches d'oxyde utilisées pour le collage des deux substrats tout en préservant les liens électriques métalliques qui garantissent les fonctions de contact électrique et mécanique entre les terminaux des détecteurs et les entrées du circuit de lecture.

Cette architecture hybride est avantageuse pour obtenir des détecteurs de très grande performance, grâce à la possibilité qu'elle offre d'optimiser un détecteur indépendamment des contraintes technologiques liées à la présence d'une technologie CMOS sur le même substrat. En revanche, elle implique des coûts de fabrication plus élevés car elle nécessite la réalisation de deux technologies sur deux substrats séparés et des opérations supplémentaires d'assemblage qui peuvent grever le coût et le rendement de fabrication de l'ensemble.

D'autres illustrations de l'état de la technique sont fournies par les documents DE10058864, WO2012015965, US20120213245, US20080237469 et EP1243903.

### EXPOSÉ DE L'INVENTION

Un but de la présente invention est de proposer un dispositif de détection infrarouge et un procédé de réalisation d'un dispositif de détection infrarouge ne présentant pas les inconvénients de l'art antérieur, c'est-à-dire évitant :
- d'utiliser un matériau sacrificiel organique,
- de réaliser des tranchées profondes d'arrêt de gravure dans des couches de semi-conducteur,
- de réduire le rapport de la surface utilisée pour réaliser les détecteurs thermiques infrarouges par rapport à la surface totale disponible pour les pixels,
- d'augmenter l'inertie thermique des détecteurs thermiques infrarouges,
- de réduire la surface consacrée aux dispositifs électroniques du circuit de lecture, et
- d'augmenter le coût de fabrication du dispositif dû à une architecture hybride du dispositif.

Pour cela, il est proposé un procédé de réalisation d'un dispositif de détection infrarouge selon la revendication 12.

La présente invention propose donc de réaliser un dispositif de détection infrarouge formé d'au moins un ou d'une matrice de détecteurs thermiques infrarouges reliés à un circuit électronique de lecture par au moins autant de liens électriques, formés par un ou plusieurs premiers vias électriquement conducteurs, que de détecteurs thermiques infrarouges. Le ou les détecteurs thermiques infrarouges sont réalisés au-dessus du circuit électronique de lecture de manière à obtenir un facteur de remplissage élevé. Compte tenu de l'utilisation d'un matériau sacrificiel minéral correspondant à une couche diélectrique inter-métal, le premier via électriquement conducteur est donc réalisé dans les couches superficielles du circuit de lecture (partie back end), ce qui simplifie la fabrication et réduit le coût de production du dispositif de détection infrarouge. De plus, un tel procédé ne nécessite pas de réaliser des tranchées profondes d'arrêt de gravure dans des couches de semi-conducteur du fait que le ou les détecteurs thermiques infrarouges sont réalisés au-dessus des couches profondes de semi-conducteur du circuit électronique de lecture, ce qui, en outre, ne réduit pas le rapport de la surface utilisée pour réaliser les détecteurs thermiques infrarouges par rapport à la surface totale disponible pour les pixels, ni la surface consacrée aux dispositifs électroniques du circuit de lecture. Enfin, le coût de réalisation d'un tel dispositif est réduit par rapport à une architecture hybride d'un dispositif de détection infrarouge.

Le terme « matériau minéral » désigne ici un matériau permettant la réalisation d'une couche diélectrique inter-métal, c'est-à-dire un matériau isolant électrique, avec par exemple une constante diélectrique, ou permittivité relative, inférieure ou égale à 3,9, permettant de limiter la capacité parasite entre les interconnexions. Il s'agit d'un matériau ne comportant pas de chaîne carbonée, tel que du SiOx ou du SiNx, ou d'un matériau de type organosilicié tel que du SiOC ou du SiOCH, ou d'un matériau de type verre fluoré tel que du SiOF.

Le détecteur thermique infrarouge est réalisé au niveau du dernier niveau d'interconnexions électriques, ou dernier niveau de métallisation, formés sur le circuit électronique de lecture, ce dernier niveau d'interconnexions électriques formant également le ou les plots de connexion du circuit électronique de lecture. Ainsi, la dernière couche de diélectrique inter-métal (ou IMD pour « InterMetal Dielectric ») disposée entre le dernier niveau d'interconnexions électriques et l'avant-dernier niveau d'interconnexions électriques est utilisée comme couche sacrificielle pour la réalisation d'un espace vide s'étendant sous le détecteur thermique infrarouge et formant donc une cavité optique du détecteur thermique infrarouge au sein de cette dernière couche de diélectrique inter-métal. Cette cavité optique du détecteur thermique infrarouge est donc réalisée sous le dernier niveau d'interconnexions électriques du circuit électronique de lecture. Le ou les détecteurs thermiques infrarouges sont donc réalisés au même niveau que le ou les plots de connexion du circuit électronique de lecture, c'est-à-dire au même niveau que le dernier niveau d'interconnexions électriques. Le ou les détecteurs thermiques infrarouges et le ou les plots de connexions se trouvent donc sensiblement à une même distance vis-à-vis de la couche d'arrêt de gravure qui est disposée sur l'avant-dernier niveau d'interconnexions électriques et qui permet de délimiter la limite de gravure lors de la réalisation de la ou des cavités optiques du ou des détecteurs thermiques infrarouges.

Les niveaux d'interconnexions électriques sont réalisés sur le circuit électronique de lecture les uns au-dessus des autres, et permettent de réaliser les différentes interconnexions électriques entre différents éléments du circuit électronique de lecture et/ou entre le circuit électronique de lecture et d'autres éléments électriques / électroniques du dispositif de détection infrarouge. Chaque niveau d'interconnexions électriques comporte une ou plusieurs portions disjointes d'une ligne métallique s'étendant sensiblement parallèlement à la couche d'arrêt de gravure, cette ou ces portions étant reliées à la ou aux lignes métalliques du ou des niveaux d'interconnexions électriques voisins (se trouvant au-dessus et/ou en dessous du niveau d'interconnexions électriques considéré) par des vias électriquement conducteurs s'étendant sensiblement perpendiculairement aux lignes métalliques à travers les couches diélectriques inter-métal. Chaque couche diélectrique inter-métal sépare deux niveaux d'interconnexions électriques voisins, et peut être sensiblement plane et s'étendre sensiblement parallèlement à la couche d'arrêt de gravure.

Dans l'invention, au moins deux niveaux d'interconnexions électriques sont réalisés sur le circuit électronique de lecture. Lorsque seuls deux niveaux d'interconnexions électriques sont réalisés sur le circuit électronique de lecture, l'avant-dernier niveau d'interconnexions électriques correspond dans ce cas au premier niveau d'interconnexions électriques. Le premier niveau d'interconnexions électriques correspond au niveau d'interconnexions électriques le plus proche du circuit électronique de lecture.

La couche sacrificielle spécifiée dans le premier procédé correspond à la première couche diélectrique inter-métal spécifiée dans le deuxième procédé. De plus, le deuxième via électriquement conducteur spécifié dans le deuxième procédé correspond au troisième via électriquement conducteur spécifié ultérieurement pour le premier procédé.

Le circuit électronique de lecture peut comporter une pluralité de dispositifs électroniques de type MOS réalisés sur et/ou dans le premier substrat semi-conducteur, et l'avant-dernier niveau d'interconnexions électriques peut comporter des troisièmes vias électriquement conducteurs réalisés dans une deuxième couche diélectrique inter-métal et reliant électriquement au moins des premières portions de la ligne métallique aux dispositifs électroniques de type MOS, et dans lequel la couche d'arrêt de gravure peut être déposée sur la deuxième couche diélectrique inter-métal.

Le détecteur thermique infrarouge est réalisé au même niveau que des plots de connexion du circuit électronique de lecture. De plus, le détecteur thermique infrarouge est relié électriquement au circuit électronique de lecture par le premier via électriquement conducteur du dernier niveau d'interconnexions électriques, la première portion de la ligne métallique de l'avant-dernier niveau d'interconnexions électriques et un des troisièmes vias électriquement conducteurs de l'avant-dernier niveau d'interconnexions électriques. Si plus de deux niveaux d'interconnexions électriques sont réalisés sur le circuit électronique de lecture, un ou des vias et une ou des portions de ligne(s) métallique(s) du ou des autres niveaux d'interconnexions électriques peuvent faire alors partie de la liaison électrique entre le détecteur thermique infrarouge et le circuit électronique de lecture. De même, l'un des troisièmes vias électriquement conducteur peut servir à former la liaison électrique entre le plot de connexion et le circuit électronique de lecture, cette liaison électrique comportant en outre le deuxième via électriquement conducteur et la deuxième portion de la ligne métallique de l'avant-dernier niveau d'interconnexions électriques.

La ligne métallique et les troisièmes vias électriquement conducteurs peuvent être à base d'au moins un matériau similaire à celui du premier via électriquement conducteur, et la deuxième couche diélectrique inter-métal peut être à base d'un matériau minéral similaire au matériau minéral de la première couche diélectrique inter-métal. De manière générale, tous les vias et les lignes métalliques des différents niveaux d'interconnexions électriques réalisés sur le circuit électronique de lecture peuvent être réalisés avec un ou plusieurs mêmes matériaux. De plus, toutes les couches diélectriques inter-métal réalisées sur le circuit électronique de lecture peuvent être réalisées en un même matériau.

Ainsi, les étapes liées à la réalisation du premier via électriquement conducteur et (en partie au moins) du détecteur thermique infrarouge peuvent être réalisées avec des techniques de la microélectronique similaires à celles liées à la réalisation des différents niveaux d'interconnexions électriques du circuit électronique de lecture.

Dans le procédé, au moins une troisième portion de la ligne métallique peut être disposée en regard du détecteur thermique infrarouge et être apte à réfléchir au moins une partie d'un rayonnement infrarouge destiné à être détecté par le détecteur thermique infrarouge. Ainsi, la ligne métallique de l'avant-dernier niveau d'interconnexions électriques peut également servir à la réalisation d'un réflecteur optique disposé en regard du détecteur thermique infrarouge. Il est notamment possible que le détecteur thermique infrarouge couplé à ce réflecteur forme une cavité interférentielle quart d'onde présentant un pic de résonance au niveau de la longueur d'onde destinée à être détectée par le détecteur thermique infrarouge.

Le procédé peut comporter en outre, entre l'étape de dépôt de la couche d'arrêt de gravure et l'étape de dépôt de la première couche sacrificielle ou première couche diélectrique inter-métal, une étape de gravure d'une partie de la couche d'arrêt de gravure qui recouvre la troisième portion de la ligne métallique. On améliore ainsi la qualité optique de la cavité interférentielle formée entre le détecteur thermique infrarouge et le réflecteur.

Le matériau minéral de la première couche sacrificielle ou première couche diélectrique inter-métal peut être un oxyde non dopé, par exemple de l'oxyde de silicium non dopé. De manière générale, chacune des couches diélectriques inter-métal peut être à base d'un oxyde non dopé, tel que de l'oxyde de silicium, ou à base de nitrure de silicium, ou encore à base de SiOC ou de SiOCH.

Selon un premier mode de réalisation du procédé, la réalisation du détecteur thermique infrarouge peut comporter la réalisation d'un empilement métal-isolant-métal apte à absorber un rayonnement infrarouge destiné à être détecté par le détecteur thermique infrarouge, et la réalisation d'au moins une portion de matériau, dont la résistivité varie en fonction de la température, couplée thermiquement avec l'empilement métal-isolant-métal et reliée électriquement au premier via électriquement conducteur. Dans un tel détecteur thermique infrarouge, la structure métal-isolant-métal forme donc un élément absorbant du détecteur thermique infrarouge, cet élément absorbant étant couplé à un élément thermométrique à base du matériau dont la résistivité varie en fonction de la température qui est relié au premier via électriquement conducteur, et donc au circuit électronique de lecture.

Selon un deuxième mode de réalisation du procédé, la réalisation du détecteur thermique infrarouge peut comporter la réalisation d'une pluralité de portions résistives aptes à absorber un rayonnement infrarouge destiné à être détecté par le détecteur thermique infrarouge, et la réalisation d'une pluralité de portions de matériau dont la résistivité varie en fonction de la température, au moins une desdites portions de matériau dont la résistivité varie en fonction de la température étant reliée électriquement au premier via électriquement conducteur. Dans un tel détecteur thermique infrarouge, les portions résistives, par exemple métalliques, forment les éléments absorbants du détecteur thermique infrarouge, ces éléments absorbants étant couplés à des éléments thermométriques à base du matériau dont la résistivité varie en fonction de la température dont au moins un élément est relié au premier via électriquement conducteur, et donc au circuit électronique de lecture.

Le procédé peut comporter en outre, entre l'étape de dépôt de la première couche sacrificielle, ou première couche diélectrique inter-métal, et l'étape de réalisation du détecteur thermique infrarouge, et par exemple après la réalisation du premier via électriquement conducteur, la réalisation d'au moins un premier contact électrique sur le premier via électriquement conducteur, le détecteur thermique infrarouge étant relié électriquement au premier via électriquement conducteur par l'intermédiaire dudit contact électrique, et comportant en outre, lorsque le procédé comporte la réalisation des troisièmes vias électriquement conducteurs, la réalisation d'au moins un deuxième contact électrique sur les troisièmes vias électriquement conducteur. Le deuxième contact électrique peut notamment former, au moins en partie, un plot de connexion du circuit de lecture permettant d'accéder électriquement au circuit électronique de lecture, ou plus généralement au dispositif de détection infrarouge, depuis l'extérieur du dispositif de détection infrarouge. Ce deuxième contact électrique correspond au plot de connexion spécifié dans le procédé.

Le procédé peut comporter en outre, entre l'étape de réalisation du détecteur thermique infrarouge et l'étape de gravure d'au moins une partie de la première couche diélectrique inter-métal, la mise en oeuvre des étapes de :
- dépôt d'une couche sacrificielle recouvrant au moins le détecteur thermique infrarouge, la couche sacrificielle comprenant au moins un matériau minéral apte à être gravé sélectivement par rapport à la couche d'arrêt de gravure ;
- gravure d'au moins une tranchée à travers au moins la première couche diélectrique inter-métal et la couche sacrificielle et délimitant des portions de la première couche diélectrique inter-métal et de la couche sacrificielle ;
- dépôt dans ladite tranchée et sur la portion de la couche sacrificielle, d'au moins une couche d'encapsulation à base d'un matériau transparent à un rayonnement infrarouge destiné à être détecté par le détecteur thermique infrarouge ;
- réalisation d'au moins une ouverture à travers la couche d'encapsulation ;

dans lequel l'étape de gravure d'au moins une partie de la première couche diélectrique inter-métal est réalisée via l'ouverture et élimine lesdites portions de la première couche diélectrique inter-métal et de la couche sacrificielle telle que le détecteur thermique infrarouge soit encapsulé dans une cavité délimitée au moins par la couche d'encapsulation et la couche d'arrêt de gravure,
et comportant en outre, après ladite étape de gravure, la mise en oeuvre d'une étape de bouchage de l'ouverture.

Selon une variante, le peut comporter en outre, entre l'étape de réalisation du détecteur thermique infrarouge et l'étape de gravure d'au moins une partie de la première couche sacrificielle ou première couche diélectrique inter-métal, la mise en oeuvre d'une étape de réalisation d'au moins un cordon métallique sur la couche d'arrêt de gravure, à travers au moins la première couche sacrificielle ou première couche diélectrique inter-métal, et comportant en outre, après l'étape de gravure d'au moins une partie de la première couche sacrificielle ou première couche diélectrique inter-métal, la solidarisation d'au moins un deuxième substrat au cordon métallique telle que le détecteur thermique infrarouge soit encapsulé dans une cavité délimitée au moins par le deuxième substrat, la couche d'arrêt de gravure et le cordon métallique, le deuxième substrat étant à base d'au moins un matériau transparent à un rayonnement infrarouge destiné à être détecté par le détecteur thermique infrarouge.

Le procédé peut comporter la réalisation d'une pluralité de détecteurs thermiques infrarouges formant une matrice de pixels du dispositif de détection infrarouge, chaque détecteur thermique infrarouge pouvant être relié électriquement au circuit électronique de lecture par au moins un premier via électriquement conducteur.

L'invention concerne également un dispositif de détection infrarouge selon la revendication 1.

Le circuit électronique de lecture peut comporter une pluralité de dispositifs électroniques de type MOS réalisés sur et/ou dans le premier substrat semi-conducteur, l'avant-dernier niveau d'interconnexions électriques peut comporter des troisièmes vias électriquement conducteurs réalisés dans une deuxième couche diélectrique inter-métal et reliant électriquement au moins des premières portions de la ligne métallique aux dispositifs électroniques de type MOS, et dans lequel la couche d'arrêt de gravure est disposée sur la deuxième couche diélectrique inter-métal.

La ligne métallique et les troisièmes vias électriquement conducteurs peuvent être à base d'au moins un matériau similaire à celui du premier via électriquement conducteur.

Au moins une troisième portion de la ligne métallique peut être disposée en regard du détecteur thermique infrarouge et être apte à réfléchir au moins une partie d'un rayonnement infrarouge destiné à être détecté par le détecteur thermique infrarouge.

La troisième portion de la ligne métallique peut ne pas être recouverte par la couche d'arrêt de gravure.

Le détecteur thermique infrarouge peut comporter un empilement métal-isolant-métal apte à absorber un rayonnement infrarouge destiné à être détecté par le détecteur thermique infrarouge, et au moins une portion de matériau, dont la résistivité varie en fonction de la température, couplée thermiquement avec l'empilement métal-isolant-métal et reliée électriquement au premier via électriquement conducteur.

En variante, le détecteur thermique infrarouge peut comporter une pluralité de portions résistives aptes à absorber un rayonnement infrarouge destiné à être détecté par le détecteur thermique infrarouge, et une pluralité de portions de matériau dont la résistivité varie en fonction de la température, au moins une desdites portions de matériau dont la résistivité varie en fonction de la température étant reliée électriquement au premier via électriquement conducteur.

Le dispositif de détection infrarouge peut comporter en outre au moins un premier contact électrique disposé sur le premier via électriquement conducteur, le détecteur thermique infrarouge pouvant être relié électriquement au premier via électriquement conducteur par l'intermédiaire dudit contact électrique.

Le détecteur thermique infrarouge peut être encapsulé dans une cavité délimitée au moins par une couche d'encapsulation, à base d'un matériau transparent à un rayonnement infrarouge destiné à être détecté par le détecteur thermique infrarouge, et par la couche d'arrêt de gravure.

En variante, le détecteur thermique infrarouge peut être encapsulé dans une cavité délimitée au moins par un deuxième substrat, la couche d'arrêt de gravure et un cordon métallique solidarisant le deuxième substrat à la couche d'arrêt de gravure, le deuxième substrat pouvant être à base d'au moins un matériau transparent à un rayonnement infrarouge destiné à être détecté par le détecteur thermique infrarouge.

Le dispositif de détection infrarouge peut comporter une pluralité de détecteurs thermiques infrarouges formant une matrice de pixels du dispositif de détection infrarouge, chaque détecteur thermique infrarouge étant relié électriquement au circuit électronique de lecture par au moins un premier via électriquement conducteur.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 6 représentent les étapes d'un procédé de réalisation d'un dispositif de détection infrarouge, objet de la présente invention, selon un premier mode de réalisation ;
- les figures 7a à 8 représentent une partie des étapes d'un procédé de réalisation d'un dispositif de détection infrarouge, objet de la présente invention, selon un deuxième mode de réalisation ;
- les figures 9 à 19 représentent des étapes de procédés de réalisation d'un dispositif de détection infrarouge, objets de la présente invention, selon des variantes du premier et du deuxième modes de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

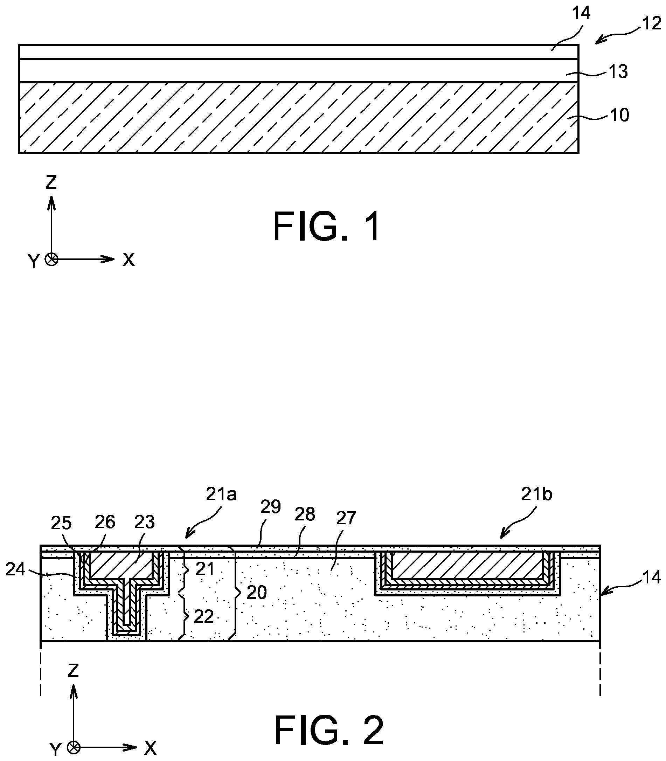

On décrit maintenant, en liaison avec les figures 1 à 6, un procédé de réalisation d'un dispositif de détection infrarouge 100 selon un premier mode de réalisation.

Le dispositif de détection infrarouge 100 comporte une pluralité de détecteurs thermiques, de type micro-bolomètre, qui vont être réalisés à partir d'un substrat semi-conducteur 10, par exemple de silicium, sur et/ou dans lequel est intégré un circuit électronique de lecture 12 réalisé en technologie CMOS. Le circuit électronique de lecture 12 comporte des couches électroniques profondes 13 (partie Front End), comprenant des couches de semi-conducteur, dans lesquelles sont réalisés des transistors, des diodes, des condensateurs et d'autres dispositifs électroniques de type MOS permettant la mise en oeuvre des fonctions électroniques du circuit de lecture 12. Un ou plusieurs niveaux d'interconnexions électriques 14 (partie Back End) reliant notamment des blocs fonctionnels du circuit de lecture 12 entre eux et destinés à former des liaisons d'entrée / sortie du circuit de lecteur 12, sont réalisés sur les couches électroniques profondes 13 du circuit de lecture 12. En revanche, le dernier niveau d'interconnexions électriques destiné à former les contacts électriques du circuit de lecteur 12 n'est pas encore réalisé au stade représenté sur la figure 1. Sur la figure 1, la référence 14 peut donc désigner un seul niveau d'interconnexions électriques, correspondant à la fois au premier niveau d'interconnexions électriques et à l'avant-dernier niveau d'interconnexions électriques, ou bien plusieurs niveaux d'interconnexions électriques empilés allant du premier niveau d'interconnexions électriques (celui en contact avec les couches électroniques 13) jusqu'à l'avant-dernier niveau d'interconnexions électriques. Le dernier niveau d'interconnexions électriques va être réalisé tel qu'il serve de moyen de support mécanique aux détecteurs thermiques infrarouges destinés à être réalisés de manière suspendue au-dessus du circuit de lecture 12 et de moyen de liaison électrique entre les entrées du circuit de lecture 12 accessibles depuis les niveaux d'interconnexions électriques 14 et les connexions électriques de sortie des détecteurs thermiques infrarouges. Ce dernier niveau d'interconnexions électriques va également être réalisé afin de former des plots de connexion électrique du circuit de lecture 12 accessibles depuis l'extérieur, c'est-à-dire pouvant être contacté électriquement depuis l'extérieur du dispositif de détection infrarouge 100. En variante, il est possible d'utiliser plusieurs (par exemple 2 ou 3) des derniers niveaux d'interconnexions électriques pour servir de moyen de support mécanique aux détecteurs thermiques infrarouges et de moyen de liaison électrique entre les entrées du circuit de lecture 12 et les connexions électriques de sortie des détecteurs thermiques infrarouges.

La figure 2 représente l'avant-dernier niveau d'interconnexions électriques 20 réalisé, faisant partie des niveaux d'interconnexions électriques 14. Ce niveau d'interconnexions électriques 20 comporte une ligne métallique 21 dont des premières portions 21a (une seule première portion 21a est représentée sur la figure 2) sont reliées électriquement et localement, par l'intermédiaire de vias électriquement conducteurs 22, ou connexions verticales, et éventuellement par l'intermédiaire du ou des niveaux d'interconnexions électriques inférieurs, aux dispositifs électroniques MOS du circuit de lecture 12. Ces premières portions 21a sont destinées à être reliées électriquement aux détecteurs thermiques infrarouges. En dehors des vias 22 qui assurent les liaisons électriques avec le niveau d'interconnexions électriques inférieur, le niveau d'interconnexions électriques 20 est isolé électriquement de la ligne métallique du niveau d'interconnexions électriques inférieur par une couche diélectrique 27, appelée diélectrique inter-métal (également appelé IMD, ou « Inter-Metal Dielectric »), par exemple composé d'oxyde de silicium non dopé (également appelé USG, ou « Undoped Silica Glass ») ou d'un oxyde de plus faible permittivité diélectrique, tel que du SiOF, du SiOC, du SiOCH, etc. Des deuxièmes portions 21b (une seule deuxième portion 21b est représentée sur la figure 2) de la ligne métallique 21, reliées ou non au niveau d'interconnexion inférieur, sont destinées à ne pas être reliées aux détecteurs thermiques infrarouges mais servir par exemple à la réalisation, au moins en partie, de plots de connexion utilisés pour le test et le câblage filaire du circuit de lecture 12 et du dispositif de détection 100 en général. Sur l'exemple de la figure 1, la deuxième portion 21b de la ligne métallique 21 de l'avant-dernier niveau d'interconnexions électriques 20 est donc reliée électriquement au circuit électronique de lecture 21 par une liaison électrique qui n'est pas visible sur cette figure.

Différentes options techniques sont possibles pour réaliser les vias 22 et la ligne métallique 21 de l'avant-dernier niveau d'interconnexions électriques 20 (et également les lignes métalliques et les vias des autres niveaux d'interconnexions électriques 14). Une première possibilité consiste à réaliser la ligne métallique 21 à partir d'aluminium avantageusement inséré entre deux couches de titane ou de nitrure de titane, et à réaliser les vias 22 en tungstène. Une deuxième possibilité est de réaliser la ligne métallique 21 et les vias 22 en cuivre selon un procédé damascène qui consiste à remplir des tranchées formées dans la couche diélectrique 27, ou diélectrique inter-métal, avec du cuivre. Il peut s'agir d'un procédé simple damascène dans lequel on réalise en deux étapes damascènes successives les vias 22 puis la ligne métallique 21, ou bien d'un procédé double damascène tel que représenté sur la figure 2, dans lequel la ligne métallique 21 et les vias 22 sont intégrés dans un processus « continu » de fabrication. Le coeur de ces éléments 21 et 22 est formé par des portions de cuivre 23 élaborées par électrolyse d'un sel cuivré en solution (dépôt ECD). Les faces inférieures et les faces latérales de ces portions de cuivre 23 sont en outre enrobées par un ensemble de couches conductrices, par exemple de nitrure de tantale 24, de tantale 25 et de cuivre 26, élaborées avantageusement par pulvérisation cathodique ionisante (également appelé iPVD) afin d'améliorer le recouvrement de ces dépôts sur les flancs verticaux. La couche de tantale 25 forme une couche barrière empêchant la diffusion du cuivre 23 et 26 dans le diélectrique inter-métal 27 et vers les couches profondes 13 du circuit de lecture 12 où ce cuivre créerait sinon des défauts électriques notamment dans les transistors et les diodes. La couche de nitrure de tantale 24 est généralement prévue pour améliorer l'adhésion de la couche de tantale 25 à la surface du diélectrique inter-métal 27. La couche de cuivre 26 sert à la fois de cathode et de couche de germination pour la croissance électrolytique des portions de cuivre 23. L'affleurement du niveau d'interconnexion 20 à la surface du diélectrique inter-métal 27 est obtenu par un procédé de polissage mécano chimique (CMP) contrôlé par une couche d'arrêt 28 par exemple à base de SiO₂. Une couche diélectrique isolante 29, par exemple à base de nitrure de silicium, recouvre la couche d'arrêt 28 et les faces supérieures des portions 21a, 21b de la ligne métallique 21, formant ainsi une barrière de diffusion vis-à-vis du cuivre.

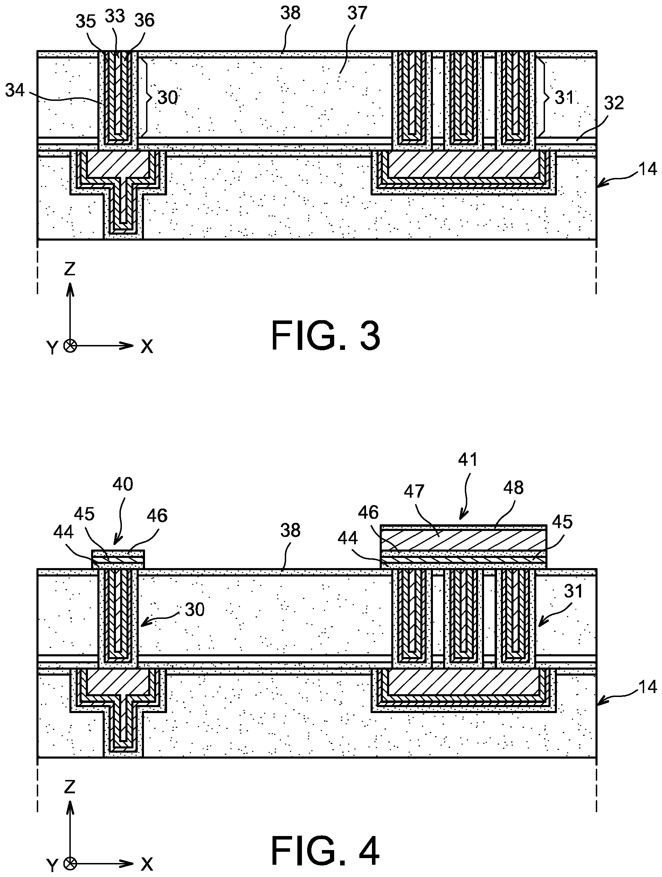

Une couche d'arrêt de gravure 32 est ensuite déposée sur la couche diélectrique isolante 29 (figure 3). La couche d'arrêt de gravure 32 est réalisée telle qu'elle soit hermétique, électriquement isolante (diélectrique) et chimiquement inerte vis-à-vis d'une attaque acide en milieu HF (acide fluorhydrique) qui sera mise en oeuvre ultérieurement pour obtenir les membranes suspendues des détecteurs thermiques infrarouges. La couche d'arrêt de gravure 32 est par exemple réalisée par un dépôt d'alumine (Al₂O₃) réalisé par ALD (« Atomic Layer Déposition ») qui a l'avantage de fournir des dépôts conformes, denses et avec peu de défauts. D'autres techniques de dépôt peuvent toutefois convenir comme par exemple la pulvérisation cathodique ou l'évaporation. La couche d'arrêt de gravure 32 a par exemple une épaisseur comprise entre environ 20 nm et 150 nm. D'autres matériaux peuvent également être utilisés pour réaliser la couche d'arrêt de gravure 32, par exemple du nitrure d'aluminium, du trifluorure d'aluminium, ou encore du silicium amorphe intrinsèque déposé par exemple par un dépôt chimique en phase vapeur assisté par plasma (PECVD). La couche d'arrêt de gravure 32 est réalisée au voisinage immédiat de la ligne métallique 21 de l'avant-dernier niveau d'interconnexions électriques 20. Cela signifie que la distance entre la couche d'arrêt de gravure 32 et la ligne métallique 21 est inférieure aux distances entre la couche d'arrêt de gravure 32 et la ou les lignes métalliques des autres niveaux d'interconnexions électriques. Dans l'exemple décrit ici, la couche d'arrêt de gravure 32 est séparée de la ligne métallique 21 uniquement par la couche diélectrique isolante 29 formant la barrière de diffusion. Il est également possible que la couche d'arrêt de gravure 32 soit en contact direct avec la ligne métallique 21 si la couche diélectrique isolante 29 est omise.

Une couche sacrificielle 37, par exemple à base d'USG, est déposée sur la couche d'arrêt de gravure 32, par exemple par un dépôt PECVD d'un composé précurseur tetraethyl orthosilicate (TEOS). L'épaisseur de la couche sacrificielle 37 peut être ajustée via la durée du dépôt réalisé, de manière à obtenir une épaisseur (dimension selon l'axe Z) par exemple comprise entre environ 1 µm et 5 µm. L'épaisseur de la couche sacrificielle 37 est notamment choisie en fonction des propriétés d'absorption souhaitées vis-à-vis d'un rayonnement infrarouge destiné à être reçu par les détecteurs thermiques infrarouges du dispositif de détection infrarouge 100 (propriétés détaillées plus loin). Une couche 38, par exemple à base de SiO₂, est ensuite déposée sur la couche sacrificielle 37 pour former une couche d'arrêt pour une planarisation mise en oeuvre ultérieurement. La couche sacrificielle 37 correspond à une autre couche diélectrique inter-métal destinée à séparer la ligne métallique 21 appartenant à l'avant-dernier niveau d'interconnexions électriques 20 vis-à-vis de la ligne métallique du dernier niveau d'interconnexions électriques qui va être ensuite réalisé.

On réalise ensuite, à travers les couches 29, 32, 37 et 38 réalisées au-dessus de la ligne métallique 21, des portions électriquement conductrices 30 reliées électriquement aux premières portions 21a de la ligne métallique 21, ainsi que des portions électriquement conductrices 31 reliées électriquement aux deuxièmes portions 21b de la ligne métallique 21. Les portions électriquement conductrices 30 et 31 forment des vias électriquement conducteurs traversant les couches 29, 32, 37 et 38. Pour réaliser ces vias 30 et 31, des zones sont définies par photolithographie puis gravées successivement à travers les couches 38, 37, 32 et 29, formant ainsi des cavités dans lesquelles les vias 30, 31 sont destinés à être formés, par exemple par un procédé simple damascène ou double damascènes. Après le remplissage de ces cavités par le ou les matériaux électriquement conducteurs de ces vias 30 et 31, une CMP est réalisée afin d'obtenir la configuration représentée sur la figure 3. Les vias 30 et 31 ont préférentiellement une forme de colonnette de section carrée par exemple comprise entre environ 0,25 µm² et 5 µm², et une hauteur équivalente à la somme des épaisseurs des couches 29, 32, 37 et de l'épaisseur restante de la couche 38 après la CMP, c'est-à-dire une hauteur par exemple comprise entre environ 1 µm et 5 µm, correspondant approximativement à celle de la couche sacrificielle 37 compte tenue des faibles épaisseurs des couches 29, 32 et 38 par rapport à celle de la couche sacrificielle 37.

La réalisation des vias 30 et 31 par un procédé damascène permet de réaliser des motifs métalliques de géométries très variées. Elles sont par exemple réalisées sous la forme d'un empilement de couches similaire à celui formant les vias 22 et la ligne métallique 21. Sur l'exemple de la figure 3, les vias 30 et 31 sont formés par une couche d'accroche 34 déposées contre les parois des cavités formées à travers les couches 29, 32, 37 et 38, d'une couche barrière 35 déposée sur la couche d'accroche 34, d'une couche de germination 36 déposée sur la couche barrière 35 et d'un coeur 33 en cuivre remplissant l'espace restant des cavités. En variante, des matériaux plus résistants vis-à-vis d'une attaque acide HF peuvent être utilisés pour la réalisation des vias 30 et 31. A titre d'exemple, une couche de TiN, préférentiellement réalisées par MOCVD pour améliorer sa densité, peut avantageusement remplacer les couches 34 et 35 en jouant à la fois le rôle de couche d'accroche et de couche barrière à la diffusion du cuivre. Les couches 34 et 35 peuvent également être remplacées par une couche d'un alliage de titane et de tungstène (TiW), comprenant par exemple environ 30 % de titane et environ 70 % de tungstène. Il est également possible d'interposer dans les cavités, préalablement aux dépôts des couches 34, 35 et 36, une première couche électriquement conductrice, par exemple à base de SiC déposé par PECVD, de manière à former une enveloppe de protection autour des vias 30 et 31. Cette couche de protection peut éventuellement remplacer la couche d'accroche 34.

Chaque via 30 est destiné à former un lien électrique entre une première portion 21a de la ligne métallique 21 (portion reliée au circuit de lecture 12) et un des détecteurs thermiques infrarouges. Au niveau de chacune des deuxièmes portions 21b destinées à former des plots de connexion (entrée et/ou sortie) du dispositif de détection infrarouge 100, un ou plusieurs vias 31 peuvent être réalisées telles que la moitié de la surface de chacune des deuxièmes portions 21b soit destinée à être en contact électriquement avec ces vias 31. Entre les vias 30 et 31, il est possible de prévoir en outre des motifs métalliques dits fantômes (dans le sens où ils n'ont pas d'utilité électrique), c'est-à-dire des portions électriquement conductrices réalisées de manière similaire aux vias 30 et 31 à travers les couches 29, 32, 37 et 38 mais reliées électriquement à aucun autre élément du circuit de lecture (ou éventuellement reliées électriquement à des portions de ligne métallique elles aussi fantômes, c'est-à-dire non reliées électriquement au circuit de lecture), c'est-à-dire non reliées à la ligne métallique 21, avec une densité comprise entre 20% et 80% (cette densité correspondant à l'espace occupé par ces vias par rapport à l'espace total où se trouvent ces vias) de manière à améliorer l'opération de CMP du procédé damascène. Cette zone intermédiaire entre les vias 30 et 31 peut aussi être utilisée pour intégrer une ou plusieurs lignes métalliques formées avec les couches 34, 35, 36, 33, dans les couches 29, 32, 37 et 38, pour interconnecter les fonctions électroniques du circuit de lecture 12 sous-jacent. Les portions électriquement conductrices réalisées à travers les couches 29, 32, 37 et 38 peuvent en variante être réalisées en tungstène déposé par CVD sous la forme d'une couche conforme de tungstène, arasée par CMP au niveau de la surface de la couche 38.

Comme représenté sur la figure 4, une couche électriquement conductrice 44 formant une barrière de diffusion au cuivre, par exemple en TaN, est déposée sur la couche 38 et sur les sommets des vias 30 et 31. Une couche de titane 45 et une couche de nitrure de titane 46 sont ensuite déposées sur la couche électriquement conductrice 44 afin d'améliorer la reprise de contact avec une couche d'aluminium 47 déposée sur la couche de TiN 46, elle-même recouverte d'une couche mince de titane et/ou de nitrure de titane 48 permettant d'améliorer les opérations de photolithographie sur l'aluminium et pour améliorer la robustesse de l'aluminium de la couche 47 vis-à-vis de phénomènes d'électro-migration et éviter la formation de protubérances. L'aluminium de la couche 47 peut être allié avec du silicium et/ou du cuivre.

Dans une variante, la couche barrière 44 peut être à base de TiN qui est plus résistant vis-à-vis d'une attaque acide en milieu HF, préférentiellement formé par MOCVD pour favoriser sa densité, et d'épaisseur au moins égale à 50 nm de manière à la doter des propriétés requises pour créer une barrière de diffusion suffisante au cuivre. Selon cette variante, la couche de titane 45 peut être omise et la couche de TiN 46 peut être réalisée par pulvérisation cathodique.

Des premiers contacts électriques 40 et des deuxièmes contacts électriques 41, disposés respectivement au-dessus des vias 30 et 31, sont ensuite réalisés par photolithographie et gravure des couches 48, 47, 46, 45 et 44, jusqu'à atteindre la couche 38 servant de couche d'arrêt de gravure. Une nouvelle étape de photolithographie et de gravure est mise en oeuvre afin de supprimer les portions restantes des couches 48 et 47 au niveau des premiers contacts électriques 40. La gravure successive de ces portions des couches 48 et 47 est mise en oeuvre en utilisant une chimie de gravure sélective vis-à-vis du matériau de la couche 46, par exemple en utilisant un procédé de gravure comportant au moins deux étapes et se terminant avec une solution de gravure par voie humide à base d'acide ortho-phosphorique pour graver la couche 48.

Les deuxièmes contacts électriques 41 reliés électriquement aux vias 31 forment des plots de connexion du dispositif de détection infrarouge 100 qui sont reliés électriquement au circuit électronique de lecture 12, ce qui justifie la conservation des portions de la couche d'aluminium 47 au niveau de ces deuxièmes contacts électriques 41 qui serviront au câblage filaire et au contact par pointe utilisé pour le test des circuits. Préférentiellement, chacun des deuxièmes contacts électriques 41 recouvre d'un seul tenant tous les vias 31 reliés à une même deuxième portion 21b de la ligne métallique 21.

Les premiers contacts électriques 40 sont chacun utilisé pour connecter électriquement un via 30 à un terminal électrique d'un détecteur thermique infrarouge.

Chaque premier contact électrique 40 est formé des couches 44, 45, 46 et leur association avec le via 30 sur lequel il repose forme un lien électrique reliant le circuit de lecture 12 à un des terminaux d'un des détecteurs thermiques infrarouges. Les motifs métalliques « fantômes » peuvent être recouverts par des contacts électriques similaires aux premiers contacts électriques 40 afin d'éviter une diffusion du cuivre, tandis que les portions des éventuelles lignes métalliques peuvent être recouvertes indifféremment avec des contacts électriques similaires aux premiers ou aux deuxièmes contacts électriques 40 et 41.

Les étapes suivantes du procédé correspondent à la réalisation notamment des détecteurs thermiques infrarouges, comportant chacun au moins un élément absorbant et au moins un élément thermométrique, et chacun relié au circuit de lecture 12 par l'intermédiaire notamment d'un premier contact électrique 40 et d'un via 30 (ainsi que par les niveaux d'interconnexions électriques inférieurs).

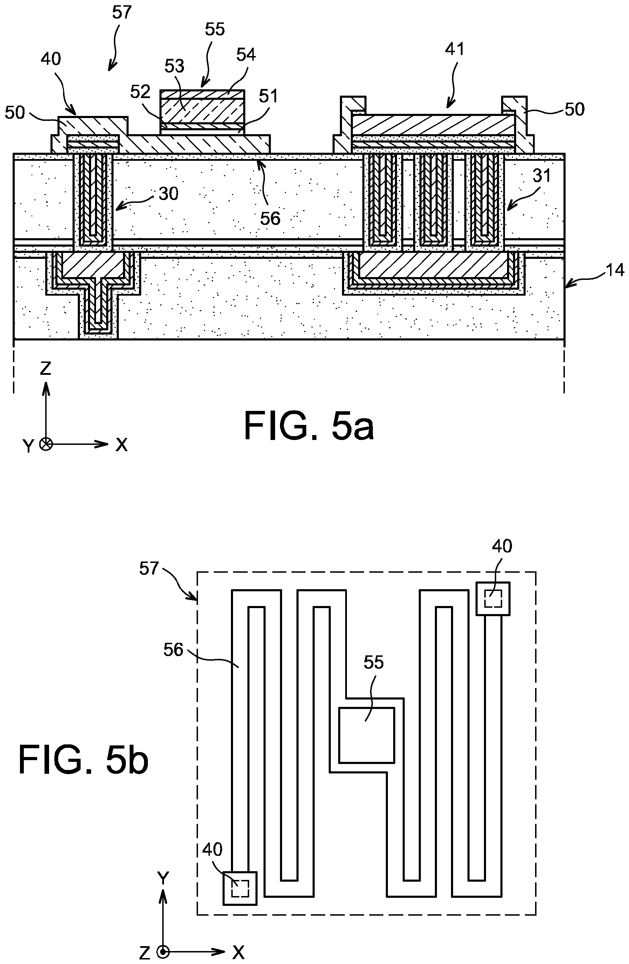

Comme représenté sur les figures 5a et 5b, une couche 50 d'un matériau dont la résistivité varie sensiblement avec la température est déposée sur les éléments précédemment réalisés. La couche 50 est par exemple à base de silicium amorphe déposé par CVD, dont la résistivité est ajustée par dopage à la croissance. La couche 50 est ensuite recouverte d'une couche diélectrique 51, isolante électriquement, par exemple en alumine (Al₂O₃). La couche diélectrique 51 peut également être en nitrure d'aluminium (AIN) également isolant électriquement et présentant une meilleure conduction thermique que l'alumine. Cette couche diélectrique 51 est optionnelle, sa présence permettant d'améliorer marginalement les performances des détecteurs thermiques infrarouges. On dépose ensuite successivement une première couche métallique 52, préférentiellement en aluminium éventuellement alliée avec quelques % de cuivre ou de silicium, une couche diélectrique 53 par exemple à base de silicium amorphe ou d'un composé amorphe de silicium et de germanium, et une deuxième couche métallique 54 préférentiellement en aluminium.

Un motif MIM (Métal-Isolant-Métal) est créé par photolithographie et gravure des couches 54, 53 et 52, en épargnant, pour chaque détecteur thermique infrarouge, au moins une portion de chacune de ces couches formant ensemble au moins une structure MIM 55 (chaque détecteur thermique infrarouge peut comporter plusieurs structures MIM) dont la géométrie est adaptée à la longueur d'onde du rayonnement infrarouge destiné à être détecté et est fonction de l'indice de réfraction du matériau de la couche 53 pour ladite longueur d'onde. La structure MIM 55 forme une cavité longitudinale qui permet d'exciter des résonances plasmoniques aptes à absorber un rayonnement infrarouge dont la longueur d'onde correspond à la fréquence propre de la cavité. Des règles de dimensionnement de la structure MIM 55 sont par exemple décrites dans la demande de brevet français FR 11 56461. Sur l'exemple décrit ici, la structure MIM 55 est de forme sensiblement carrée de coté égal à environ 1,7 µm et dont la couche intermédiaire 53, à base de sulfure de zinc d'indice de réfraction égal à environ 2,2, est prévue avec une épaisseur d'environ 180 nm, permettant une détection d'un rayonnement infrarouge de longueur d'onde égale à environ 8 µm. La gravure définissant la structure MIM 55 peut être prévue pour éliminer (comme c'est le cas sur la figure 5a) ou non les portions de la couche 51 non recouvertes par la structure MIM 55. Dans ce dernier cas, la couche 51 se retrouve sur la face supérieure de la couche 50, l'ensemble formé par les couches 50, 51 pouvant alors être considéré comme une seule couche. Une photolithographie et une gravure de la couche 50 (ou des couches 50 et 51) définissent des éléments thermométriques 56 formant chacun, avec l'élément absorbant (vis-à-vis du rayonnement infrarouge à détecter) formé par la structure MIM 55 associé à l'élément thermométrique 56 et avec au moins un premier contact électriques 40 (deux sur l'exemple des figures 5a et 5b) associé à l'élément thermométrique 56, un détecteur thermique infrarouge 57. Préférentiellement, des portions de la couche 50 sont conservées sur le sommet des motifs métalliques « fantômes » et sur le sommet des éventuelles portions de ligne métallique.

La figure 5b représente une vue de dessus du détecteur thermique infrarouge 57, comprenant la structure MIM 55 localisée sensiblement au centre du détecteur, c'est-à-dire au centre du pixel, en contact avec la face supérieure de l'élément thermométrique 56 réalisé sous la forme d'un serpentin gravé dans la couche 50 et relié aux deux premiers contacts électriques 40. Lorsque le détecteur 57 reçoit un rayonnement infrarouge, l'énergie de ce rayonnement infrarouge est absorbée par la structure MIM 55 et transformée en chaleur qui est communiquée à l'élément thermométrique 56. Il s'établit alors un gradient de température le long de l'élément thermométrique 56 entre une zone chaude à proximité de la structure MIM 55 et des zones froides au niveau des contacts électriques 40, en shunt thermique avec le substrat CMOS via des liens électriques formés par les vias 30 (le substrat CMOS correspond à tous les éléments se trouvant sous les vias 30 et 31). La résistance électrique de l'élément thermométrique 56 s'en trouve modifiée avec une sensibilité d'autant plus élevée que l'on est proche de la structure MIM 55. La présence de la couche électriquement isolante 51 entre l'élément thermométrique 56 et la première couche métallique 52 de la structure MIM 55 est avantageuse, sans quoi la partie la plus sensible de l'élément thermométrique 56 située sous la structure MIM 55 serait shuntée par la forte conductivité électrique de la face inférieure de la structure MIM 55.

L'étape de gravure définissant l'élément thermométrique 56 peut aussi servir à éliminer la couche 50 sur une partie de la surface des deuxièmes contacts électriques 41, comme visible sur la figure 5a. Cette élimination est avantageuse si on ne prévoit pas de poursuivre la fabrication des détecteurs thermiques 57 avec un procédé additionnel visant à intégrer un confinement des détecteurs thermiques 57, solidairement avec le substrat. Elle est donc bien adaptée au cas où le dispositif de détection 100 est monté dans un boîtier étanche (sous vide ou sous gaz contrôlé) ou si le dispositif de détection 100 n'est pas destiné à fonctionner sous atmosphère confinée. Il est possible de prévoir de terminer cette étape de gravure par une opération dite de « back sputtering » visant à supprimer aussi la couche de nitrure de titane 48 qui recouvre la surface des deuxièmes contacts électriques 41.

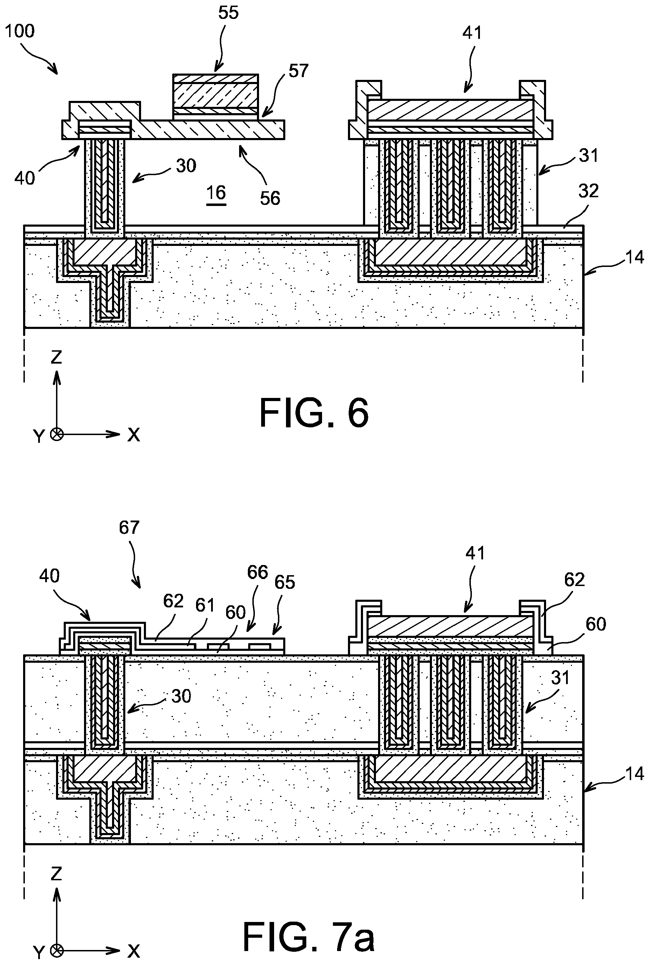

Le dispositif de détection 100 peut être achevé en gravant les couches 37 et 38 telles que les éléments thermométriques 56 et les structures MIM 55 forment des membranes suspendues (figure 6). Les couches 37 et 38 sont par exemple éliminées par une attaque chimique à l'acide fluorhydrique (HF) en phase vapeur. Un traitement HF en phase vapeur est ici préféré à une gravure chimique en phase liquide qui pourrait conduire à un effondrement des structures suspendues des détecteurs thermiques infrarouges 57 du fait de la tension superficielle du liquide qui s'exerceraient sur elles.

L'acide fluorhydrique en phase vapeur est connu pour éliminer parfaitement l'oxyde de silicium non dopé tel que l'USG de la couche 37 et le SiO₂ de la couche 38. En revanche, le HF est inerte vis-à-vis de la couche d'alumine 32 qui constitue donc une barrière efficace pour empêcher la propagation de l'attaque chimique vers les couches diélectriques IMD des niveaux d'interconnexions électriques inférieurs. De même, le HF est inerte vis-à-vis des couches 50, 51, 52, 53, 54 présentes dans les détecteurs thermiques infrarouges 57, respectivement en silicium amorphe, en alumine, en aluminium, en alliage amorphe de silicium et de germanium et en aluminium. Comme indiqué dans la description du procédé, les vias électriquement conducteurs 30 et 31 sont eux aussi réalisés à partir de matériaux comme le cuivre ou le tungstène qui sont peu sensibles à l'acide fluorhydrique et qui peuvent en outre être encapsulées par des couches de protection plus résistantes à l'HF, comme du nitrure de titane ou un alliage de titane et de tungstène ou du carbure de silicium.

Des portions de matériaux issues des couches 37 et 38 sont conservées autour des vias 31 afin d'améliorer la robustesse mécanique des deuxièmes contacts électriques 41. Cela permet en outre de réduire le temps de gravure nécessaire, et donc le coût lié à cette gravure. Ces portions sont conservées du fait que la dimension de ces vias selon l'axe X ou Y, par exemple égale à environ 100 µm, est bien supérieure à celle selon l'axe Z, par exemple comprise entre environ 1 et 10 µm.

Le dispositif de détection infrarouge 100 ainsi obtenu comporte un ou plusieurs détecteurs thermiques infrarouges 57 réalisés de manière suspendue au-dessus de la couche d'arrêt de gravure 32 et au-dessus de l'avant-dernier niveau d'interconnexions électriques 20. Un espace vide 16 entoure chaque via 30, c'est-à-dire que chaque via 30 n'est pas en contact avec du matériau diélectrique de la couche diélectrique inter-métal 37 se trouvant entre l'avant-dernier et le dernier niveau d'interconnexions électriques. Chaque espace vide 16 s'étend sous chaque détecteur thermique infrarouge 57 et forme ainsi une cavité optique de chaque détecteur thermique infrarouge 57. Dans le dispositif de détection infrarouge 100, le ou les détecteurs thermiques infrarouges 57 sont donc réalisés au même niveau que le ou les plots de connexions 41 formés par le dernier niveau d'interconnexions électriques, c'est-à-dire que la distance séparant la couche d'arrêt de gravure 32 d'un détecteur thermique infrarouge 57 est sensiblement égale à la distance séparant un plot de connexion 41 de cette couche d'arrêt de gravure 32.

On décrit maintenant un procédé de réalisation d'un dispositif de détection infrarouge 200 selon un deuxième mode de réalisation, comportant des détecteurs thermiques infrarouges 67 réalisés comme décrit dans le document US 5 912 464. Dans ce deuxième mode de réalisation, les étapes précédemment décrites en liaison avec les figures 1 à 4 sont tout d'abord mises en oeuvre.

Comme représenté sur la figure 7a, une première couche 60 à base d'un matériau dont la résistivité varie sensiblement avec la température, par exemple similaire à celui de la couche 50, est déposée. Une couche résistive 61, par exemple métallique ou à base de semi-conducteur dopé, dont le couple résistivité - épaisseur est adapté pour optimiser l'absorption du rayonnement infrarouge par couplage résistif des électrons de cette couche, est déposée sur la première couche 60. Une étape de photolithographie et de gravure est mise en oeuvre afin de fragmenter la couche résistive 61 en différentes portions 65 de manière à créer d'une part des éléments absorbants formés par des portions restantes de la couche résistive 61 et d'autre part des éléments thermométriques 66 entre lesdites portions restantes, là où la couche résistive 61 a été éliminée. Une deuxième couche 62 d'un matériau sensible à la température, par exemple et préférentiellement similaire à celui la première couche 60, est ensuite déposée. Bien qu'optionnelle, la deuxième couche 62 permet d'obtenir une structure de couches symétriques qui permet d'une part de compenser les contraintes mécaniques qui résultent de l'effet bilame entre les couches 60 et 61, et d'autre part de protéger totalement la couche résistive 61, qui est généralement très fine, vis-à-vis de la gravure chimique en milieu HF utilisée par la suite pour former les membranes suspendues des détecteurs thermiques infrarouges 67. Chaque détecteur thermique infrarouge 67 comportant des éléments thermométriques 66, des éléments résistifs 65 et un ou plusieurs premiers contacts électriques 40 est défini par photolithographie et gravure des couches 60 et 62.

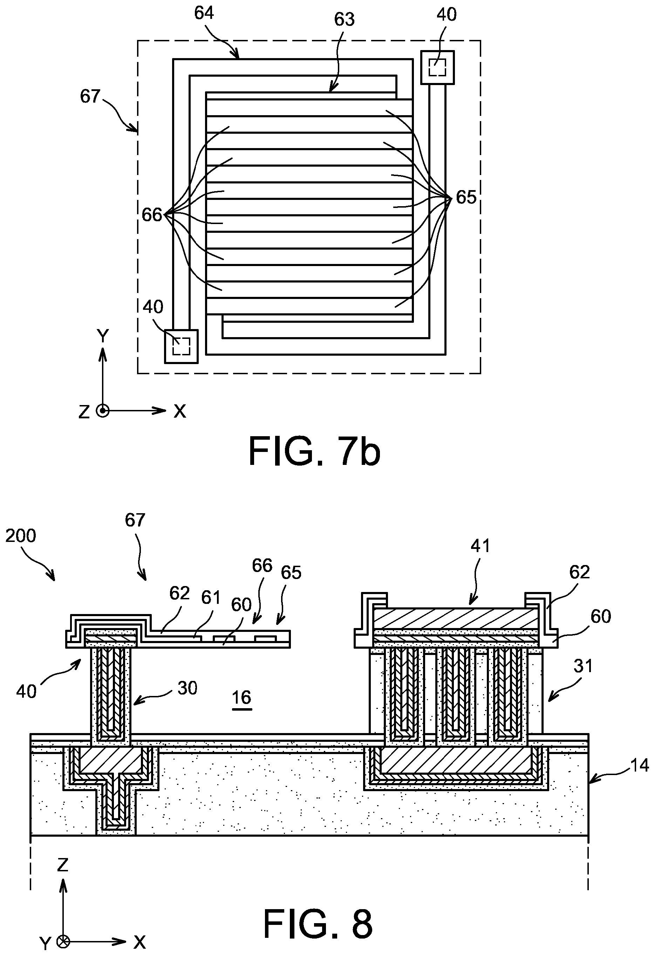

La figure 7b montre une vue de dessus d'un exemple d'un tel détecteur thermique 67, comportant un élément central 63 formé dans le matériau sensible à la température et comportant les éléments résistifs 65 sous la forme de rubans résistifs, par exemple métalliques. Les espaces entre les rubans résistifs forment un élément thermométrique global formé de plusieurs éléments thermométriques unitaires 66 connectés en série par les rubans résistifs intermédiaires de plus faible résistance. D'autre formes sont possibles pour former les éléments résistifs 65, comme par exemple des peignes interdigités comportant des segments disposés dans des directions perpendiculaires pour réaliser respectivement les dents et le dos des peignes. Dans sa portion périphérique, l'élément central 63 se prolonge par des portions de sections réduites 64, formées par des parties de l'empilement des couches 60, 61 et 62 et chacune reliée par leur extrémité à un premier contact électrique 40. L'énergie infrarouge est absorbée par les éléments 65 et transformée en chaleur qui est transmise aux éléments thermométriques 66. Il s'établit alors un gradient de température entre l'élément central 63 qui s'échauffe et les extrémités des portions de section réduite 64 en shunt thermique avec le substrat via les liens électriques formés par les vias 30. La résistance électrique des motifs thermométriques 66 s'en trouve modifiée et sa mesure reflète l'amplitude du signal infrarouge capturé par les éléments 65.

La suite du procédé pour le traitement des deuxièmes contacts électriques 41 et pour l'obtention des membranes suspendues est identique à celle déjà décrite pour le dispositif de détection 100 selon le premier mode de réalisation, et correspond notamment à la gravure des couches 37 et 38 telles que les détecteurs thermiques 67 comportent des membranes suspendues. La vue en coupe de la figure 8 montre que le détecteur thermique infrarouge 67 est formé notamment d'un film résistif fragmenté 61, entouré des couches diélectriques 60 et 62 transparentes à l'infrarouge, le tout suspendu dans un milieu diélectrique. Selon les lois de Maxwell, l'absorption d'un film résistif continu séparant deux demi-espaces diélectriques infinis est égale à 50 % quelle que soit la longueur d'onde, si le rapport de la résistivité ρ sur l'épaisseur e de la couche résistive 61 est voisin de 60.π, soit 188 Ω, et si on fait l'hypothèse que l'indice de réfraction et le coefficient d'extinction de la couche résistive 61 sont égaux, ce qui est généralement le cas dans le domaine des longueurs d'ondes infrarouges. Cette résistance de 188 Ω peut être obtenue en réalisant la couche résistive 61 à base de TiN déposé par pulvérisation cathodique, de résistivité égale à environ 150 µΩ.cm, d'épaisseur égale à environ 16 nm et fragmenté de telle manière que son taux de couverture (surface des éléments résistifs 65 par rapport à la surface totale de l'élément central 63, dans le plan (X ;Y)) soit de 50 % environ pour obtenir une résistivité apparente de 300 µΩ.cm. A titre d'exemple, un tel film de nitrure de titane d'épaisseur égale à 16 nm et de résistivité égale à 150 µΩ.cm, fragmenté sous la forme de bandes de largeur égale à 2,5 µm espacées de 2,5 µm jusqu'à des bandes de 4 µm espacée de 4 µm, convient pour détecter un rayonnement infrarouge de longueur d'onde comprise entre environ 8 µm et 12 µm.

Comme pour le dispositif de détection infrarouge 100, le dispositif de détection infrarouge 200 ainsi obtenu comporte un ou plusieurs détecteurs thermiques infrarouges 67 réalisés de manière suspendue au-dessus de la couche d'arrêt de gravure 32 et au-dessus de l'avant-dernier niveau d'interconnexions électriques 20. Un espace vide 16 entoure chaque via 30, c'est-à-dire que chaque via 30 n'est pas en contact avec du matériau diélectrique de la couche diélectrique inter-métal 37 se trouvant entre l'avant-dernier et le dernier niveau d'interconnexions électriques. Chaque espace vide 16 s'étend sous chaque détecteur thermique infrarouge 67 et forme ainsi une cavité optique de chaque détecteur thermique infrarouge 67. De plus, le ou les détecteurs thermiques infrarouges 67 sont réalisés au même niveau que le ou les plots de connexions 41 formés par le dernier niveau d'interconnexions électriques, c'est-à-dire que la distance séparant la couche d'arrêt de gravure 32 d'un détecteur thermique infrarouge 67 est sensiblement égale à la distance séparant un plot de connexion 41 de cette couche d'arrêt de gravure 32.

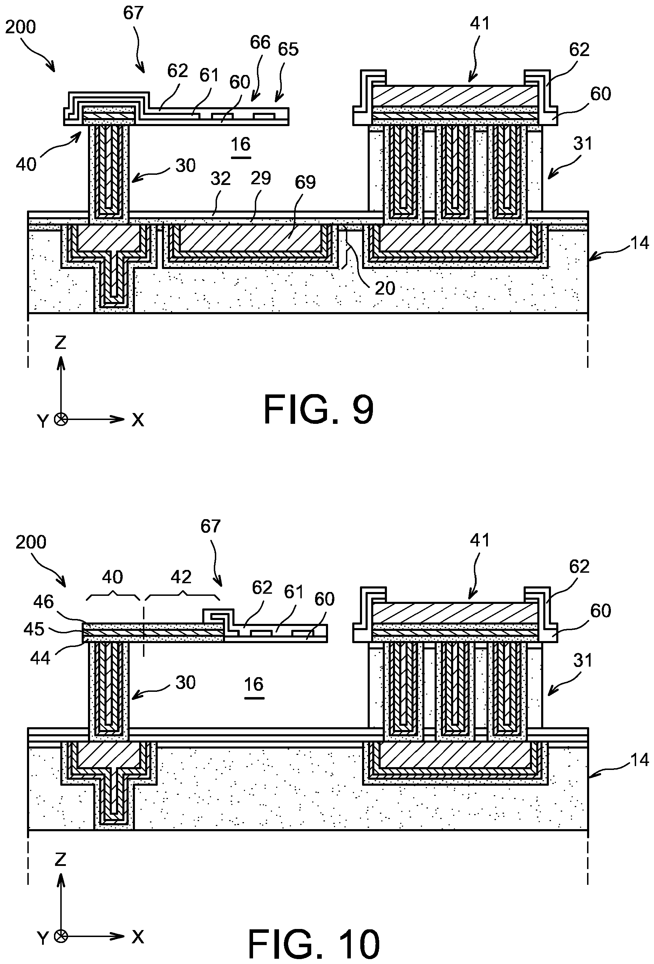

Selon une première variante du deuxième mode de réalisation, l'absorption du dispositif de détection 200 peut être améliorée au-delà de 50 % en prévoyant de coupler un élément réflecteur 69 positionné en regard et sous chacun des détecteurs thermiques 67, de surface sensiblement identique au détecteur thermique 67 et espacé du détecteur d'une distance égale au quart de la longueur d'onde destinée à être mesurée. La figure 9 représente une telle variante où un élément réflecteur 69 est réalisé au moyen d'une portion de la ligne métallique 21 de l'avant-dernier niveau d'interconnexion 20. Bien que la figure 9 se rapporte à une technologie back-end damascène cuivre, il est possible de réaliser, avec le même avantage d'amélioration de l'absorption, l'élément réflecteur 69 en technologie back-end aluminium, dans la mesure où le cuivre et l'aluminium ont des qualités de réflexion élevées et voisines dans le domaine infrarouge. La vue en coupe de la figure 9 montre que le détecteur thermique infrarouge 67 est formé, de bas en haut en partant de l'avant dernier niveau d'interconnexion 20 du substrat CMOS, d'un réflecteur métallique 69 formé dans le niveau d'interconnexion 20, de deux couches diélectriques 29, 32 de faible épaisseur, de l'espace vide 16 formant une lame d'air 16 d'épaisseur préférentiellement comprise entre environ 2 µm et 2,5 µm en ajustant l'épaisseur de la couche sacrificielle 37, d'un empilement de couches comprenant au moins une couche résistive fragmentée 61, les autres couches de nature diélectrique 60, 62 étant transparentes à l'infrarouge.

Le réflecteur 69, la lame d'air 16 et la couche résistive semi-absorbante 61 fragmentée forment une cavité interférentielle quart d'onde qui présente un pic de résonnance pour une longueur d'onde égale à 4 fois l'épaisseur de la lame d'air 16, autrement dit 10 µm et donc bien adaptée à l'imagerie thermique. Dans ces conditions et selon les lois de Maxwell, cette cavité peut être prévue pour obtenir une absorption voisine de 100 % au voisinage de 10 µm de longueur d'onde si le rapport ρ/e de la résistivité sur l'épaisseur de la couche résistive 61 est voisin de 120.Ω, soit 377 Ω. Cette résistance peut être obtenue en réalisant la couche résistive 61 à base de nitrure de titane déposé par pulvérisation cathodique, de résistivité égale à environ 150 µΩ.cm, d'épaisseur égale 8 nm et fragmentée de telle manière que son taux de remplissage (surface des éléments résistifs 65 par rapport à la surface totale de l'élément central 63, dans le plan (X ;Y)) soit de 50 % environ pour obtenir une résistivité apparente de 300 µΩ.cm. La fragmentation de la couche résistive 61 doit aussi répondre à des règles de dessin telles que le motif des éléments fragmentés est répété suivant un pas compris typiquement entre une fois et une demi fois la longueur d'onde d'intérêt pour obtenir une absorption moyenne supérieure à 90%. Des bandes de largeur égale à environ 2,5 µm espacées d'environ 2,5 µm jusqu'à des bandes d'environ 4 µm espacées d'environ 4 µm conviennent pour détecter un rayonnement compris entre environ 8 µm et 12 µm.

Cette première variante de réalisation couplant des éléments réflecteurs formés dans le niveau d'interconnexion 20 du substrat CMOS aux détecteurs thermiques peut également s'appliquer au premier mode de réalisation précédemment décrit.

La figure 10 représente le dispositif de détection 200 obtenu selon une deuxième variante du deuxième mode de réalisation, dans laquelle une extension 42 des premiers contacts électriques 40 est réalisée. L'extension 42 du premier contact électrique 40, formée à partir des couches 44, 45 et 46 formant également le premier contact électrique 40, sert à la fois de connexion électrique et d'isolation thermique entre le premier contact électrique 40 et l'élément thermométrique du détecteur thermique 67 qui est relié électriquement au via 30 par l'intermédiaire du premier contact électrique 40 et de l'extension 42. L'extension 42 est avantageusement prévue avec un facteur de forme allongé de manière à reproduire l'élément de section réduite 64 précédemment décrit. Selon cette disposition, l'élément de section réduite ainsi formé est dépourvu des couches 60, 61 et 62 au profit des couches 44, 45 et 46, ce qui permet de réduire significativement sa section car les couches 60 et 62 du matériau sensible à la température sont généralement prévues épaisses pour améliorer le rapport signal à bruit de l'élément thermométrique.

Cette deuxième variante de réalisation dans laquelle une extension 42 des premiers contacts électriques 40 est réalisée peut également s'appliquer au premier mode de réalisation précédemment décrit.

Les modes de réalisation et variantes précédemment décrits sont avantageux car trois étapes de photolithographie suffisent pour construire des détecteurs thermiques infrarouges sous forme de micro-bolomètres sur un substrat CMOS au niveau du dernier niveau d'interconnexions électriques et dans lequel des liens électriques sont prévus, au moins dans l'avant-dernier niveau d'interconnexions électriques, pour relier les terminaux des détecteurs thermiques aux entrées du circuit de lecture 12 formé dans le substrat CMOS. Il en découle un coût de fabrication très avantageux. Les modes de réalisation et variantes suivants permettent d'améliorer les performances de détection du dispositif de détection, moyennant un nombre d'étapes de photolithographie plus important.

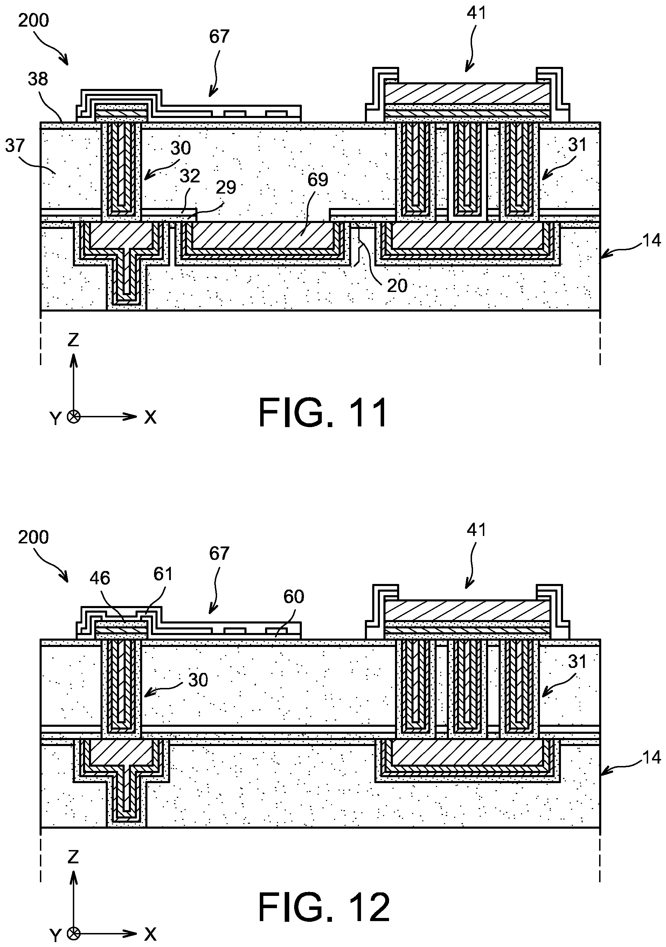

La figure 11 représente la variante précédemment décrite en liaison avec la figure 9, dans laquelle un niveau de photolithographie supplémentaire est prévu pour définir et ouvrir, par gravure, des fenêtres dans les couches 29, 32 dans le but de dégager la face supérieure du réflecteur 69 de toutes couches diélectriques superficielles susceptibles d'absorber l'énergie infrarouge et de dégrader en conséquence la qualité optique de la cavité interférentielle quart d'onde formée entre le détecteur thermique 67 et le réflecteur 69. Cette opération de photolithographie et de gravure intervient entre l'étape de dépôt de la couche d'arrêt de gravure 32 et l'étape de dépôt de la couche sacrificielle 37. Cette variante s'applique avantageusement au cas où on prévoit un détecteur thermique en association avec une cavité quart d'onde et un réflecteur.

Il est également possible que ces étapes de photolithographie et gravure ne soient mises en oeuvre pour n'éliminer que la partie de la couche d'arrêt de gravure 32 au niveau du réflecteur 69 et non la partie de la couche diélectrique 29 disposée en regard du réflecteur 69 formant une barrière de diffusion au cuivre notamment pendant des traitements thermiques qui accompagnent la suite du procédé. Dans ce cas, la partie de la couche diélectrique 29 peut être éliminée de la surface du réflecteur 69 au cours d'une étape ultérieure mise en oeuvre juste après l'opération d'élimination des couches 37, 38 par attaque acide en milieu HF vapeur, étape au-delà de laquelle les traitements thermiques sont modérés, typiquement inférieurs à 200°C.

L'acide fluorhydrique en phase vapeur est connu pour éliminer parfaitement l'oxyde de silicium tel que l'USG de la couche 37 et le dioxyde de silicium de la couche 38. En revanche il crée des résidus nitrurés solides lorsqu'il est en contact avec un nitrure de silicium tel que celui de la couche 29. En prolongeant suffisamment son exposition aux vapeurs d'HF, il est possible de transformer le matériau de la couche diélectrique 29 sur toute son épaisseur, en résidus nitrurés localisés dans les zones où la couche d'arrêt de gravure 32 a été préalablement gravée. En dehors de ces zones d'ouverture et d'une extension de faible étendue sous la couche 32 en périphérie de ces zones d'ouverture, le nitrure de silicium de la couche 29 est conservé en l'état grâce à la protection apportée par la couche 32. Les résidus nitrurés sont alors avantageusement éliminés par un traitement thermique de sublimation, par exemple d'environ 30 minutes à une température égale à environ 180°C sous une pression d'environ 10 Pascal, qui est privilégié pour éviter toute transition par une phase liquide qui pourrait effondrer les structures suspendues du fait des tensions superficielles qui se développeraient.

Selon une autre variante représentée sur la figure 12 et s'appliquant préférentiellement au dispositif de détection 200 selon le deuxième mode de réalisation, il est possible de prévoir un niveau de photolithographie supplémentaire permettant de définir, par gravure locale de la couche 60 de matériau sensible à la température, une zone de contact électrique supplémentaire entre la couche résistive 61 et la couche supérieure 46 d'un des premiers contacts électriques 40. Une telle zone de contact électrique permet de réduire avantageusement la résistance d'accès au détecteur thermique 67 et d'augmenter en conséquence sa sensibilité thermique. Cette étape de photolithographie supplémentaire s'insère entre le dépôt de la couche 60 et le dépôt de la couche résistive 61. Le contact électrique peut être formé par la prolongation de la couche 61 dans l'ouverture créée par la gravure de la couche 60 jusqu'au contact avec la couche 46, comme représenté sur la figure 11. Une autre variante (non représentée) peut consister à former une zone de contact électrique supplémentaire en utilisant une couche métallique additionnelle déposée après la couche résistive 61 et définie par photolithographie de manière à recouvrir l'ouverture créée dans la couche 60, la couche métallique additionnelle étant gravée en dehors de cette zone de recouvrement pour limiter son encombrement à la seule surface nécessaire à une bonne reprise de contact électrique entre les couches 46 et 61. La nature et l'épaisseur de la couche métallique additionnelle sont choisies de manière à posséder une section continue entre le haut et le bas de l'ouverture créée dans la couche 60.

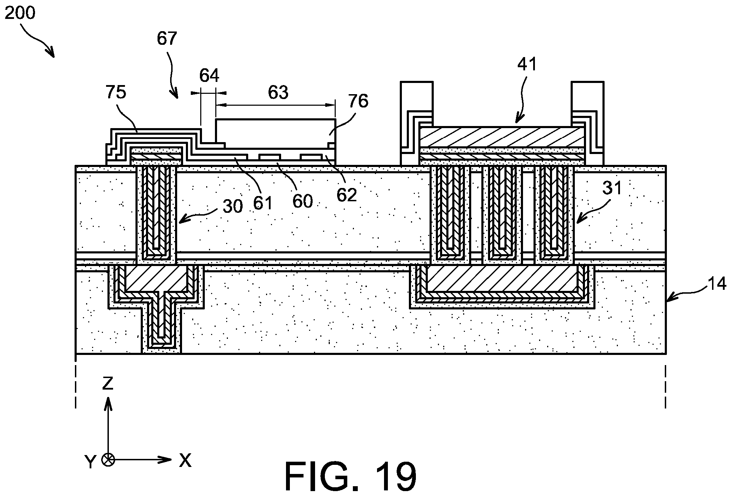

Selon une autre variante représentée sur la figure 19 et s'appliquant préférentiellement au dispositif de détection 200 selon le deuxième mode de réalisation, il est en outre possible de prévoir entre l'étape de dépôt de la deuxième couche 62 d'un matériau sensible à la température et l'étape de définition des détecteurs thermiques infrarouges 67 par gravure des couches 60 et 62 :
- une étape de dépôt d'une couche temporaire 75, supprimable par exposition aux vapeurs d'HF, par exemple à base d'oxyde de silicium,
- une étape de photolithographie et de gravure prévue pour éliminer une portion de la couche temporaire 75 dans une zone interne et légèrement en retrait de l'élément central 63,
- une étape de dépôt d'une troisième couche 76 d'un matériau sensible à la température, préférentiellement de même nature que 60 et 62, mais d'épaisseur sensiblement plus importante,
- une étape de photolithographie et de gravure pour éliminer une portion de la troisième couche 76 d'un matériau sensible à la température en épargnant une zone correspondant à l'élément central 63. La couche temporaire 75 est avantageusement utilisée comme couche d'arrêt pour l'étape de gravure de la troisième couche 76 de matériau sensible à la température.

Selon cette variante, le détecteur thermique infrarouge 67 est formé d'un élément central 63 composé, outre des éléments résistifs 65 par exemple sous la forme de rubans métalliques, d'éléments thermométriques 66 sous la forme de trois couches 60, 62, 76 d'un matériau sensible à la température dont l'épaisseur totale est sensiblement supérieure à la somme des épaisseurs de 60 et 62. Il s'ensuit une diminution du bruit électrique des éléments thermométriques 66 selon une loi inversement proportionnelle à l'épaisseur des éléments thermométriques 66. La couche temporaire 75 est automatiquement supprimée au cours d'une étape ultérieure de gravure d'au moins une partie de la première couche sacrificielle, de sorte que le détecteur thermique infrarouge 67 est aussi formé de portions de sections réduites 64 sous la forme de trois couches 60, 61, 62 empilées dont l'épaisseur est sensiblement inférieure à l'épaisseur de l'élément central 63. Il s'ensuit une diminution de la conductance thermique des éléments 64 et par voie de conséquence une meilleure isolation thermique de l'élément central 63 et un gain de sensibilité du détecteur thermique infrarouge 67.

D'autres formes de détecteurs thermiques peuvent convenir dans la mesure où aucune des faces apparentes de ces détecteurs ne comporte de matériaux susceptibles d'être attaqués par la gravure mise en oeuvre pour supprimer les couches 37 et 38 telle qu'une gravure chimique en milieu HF. De tels détecteurs comportent par exemple du silicium, du germanium, de l'aluminium (allié ou non avec du cuivre et/ou du silicium), du tungstène, du nitrure de titane, un alliage de titane tels que du TiAl ou du TiW, du siliciure de molybdène, du cuivre, de l'or, du nickel, du chrome, du ruthénium, un alliage cuivre-étain, de l'alumine, du carbure de silicium, du carbone amorphe, du trifluorure d'aluminium, ou encore du nitrure d'aluminium.

Pour tous les modes de réalisation et variantes précédemment décrits, il est possible de réaliser un confinement, ou encapsulation, des détecteurs thermiques, comme par exemple décrit dans le document US 6 753 526, solidairement avec le substrat sur lequel ces éléments sont formés, comme décrit ci-dessous.

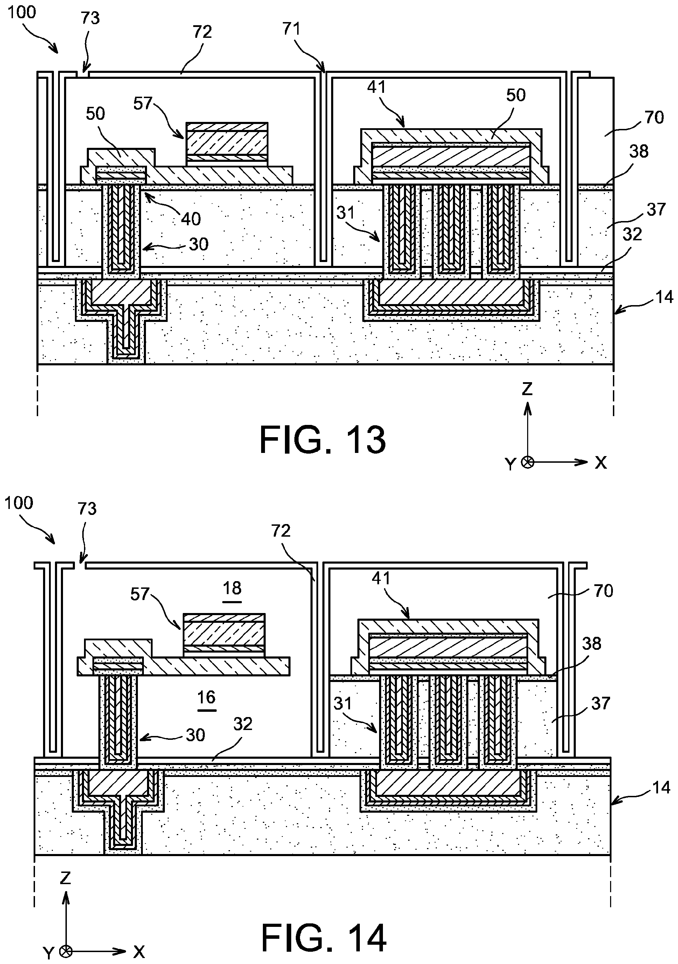

Selon une première approche de confinement dans laquelle l'encapsulation est réalisée en utilisant le dépôt de couches minces, l'étape de gravure de la couche 50 (ou des couches 60 et 62 dans le cas du deuxième mode de réalisation) définissant et séparant les détecteurs thermiques les uns des autres, est mise en oeuvre afin d'épargner préférentiellement les portions de cette couche 50 recouvrant les deuxièmes contacts électriques 41. Comme représenté sur la figure 13, une deuxième couche diélectrique sacrificielle 70, par exemple et préférentiellement de même nature que la première couche sacrificielle 37 (en USG par exemple) est déposée au-dessus des éléments précédemment réalisés, et planarisée. L'épaisseur de cette deuxième couche sacrificielle 70 est par exemple comprise entre environ 1 µm et 3 µm. Des tranchées 71 sont définies par photolithographie et gravées dans les couches 70, 38 et 37, débouchant par exemple sur la couche d'arrêt de gravure 32, ou éventuellement sur des couches inférieures à la couche 32. Les tranchées 71 sont définies telles qu'elles forment des périmètres fermés lorsqu'elles entourent un ou plusieurs détecteurs thermiques. En dehors de la zone où sont formés les détecteurs thermiques, des tranchées peuvent être prévues mais pas nécessairement, leur périmètre pouvant être indifféremment ouvert ou fermé. Sur l'exemple de la figure 13, des tranchées 71 sont également prévues de part et d'autre d'un deuxième contact électrique 41.

Une couche d'encapsulation 72 transparente à l'infrarouge est ensuite déposée selon une technique de dépôt adaptée pour obtenir un bon recouvrement des flancs verticaux des tranchées 71. Il peut s'agir par exemple d'une couche de silicium amorphe élaboré par CVD ou par iPVD, d'une épaisseur typiquement comprise entre environ 400 nm et 1200 nm lorsqu'elle est mesurée sur une surface plane. Le dépôt de la couche d'encapsulation 72 sur une surface structurée par des tranchées 71 dont le périmètre est fermé conduit à la formation de capsules hermétiques, réalisées avec le matériau de la couche d'encapsulation 72 et formant, en contact avec le substrat, des volumes dans lesquels sont enfermés les détecteurs thermiques. Comme représenté sur la figure 13, le dépôt de la couche d'encapsulation 72 peut également former des capsules en dehors de la zone des détecteurs thermique, par exemple autour des deuxièmes contacts électriques 41. Des orifices 73, ou ouvertures, sont ensuite réalisés par photolithographie et gravure dans la couche d'encapsulation 72. Chaque orifice 73 peut être de forme carrée, rectangulaire, circulaire ou oblong, sa petite dimension étant typiquement comprise entre environ 200 nm et 600 nm. Au moins un orifice 73 par périmètre fermé entourant au moins un détecteur thermique est prévu. Plus avantageusement, les orifices 73 peuvent être réalisés à travers la couche d'encapsulation 72 avec un pas de répétition de 10 µm environ. Préférentiellement, les capsules entourant les deuxièmes contacts électriques sont dépourvues d'orifice.

Comme représenté sur la figure 14, les couches sacrificielles 37, 70 et la couche 38 sont éliminées, par une attaque chimique en HF vapeur, formant des cavités 18 renfermant les détecteurs thermiques 57, 67 ainsi que les espaces vides 16, via les orifices 73. Les agents réactifs et les produits de la réaction chimique, tous sous forme gazeux, sont respectivement introduits et évacués par l'intermédiaire des orifices 73. La propagation de la gravure chimique par l'HF est contrôlée verticalement par la présence de la couche barrière 32 et par le matériau de la couche d'encapsulation 72 dans les autres directions. En prévoyant un orifice 73 au moins tous les 10 µm, la totalité des couches 37, 38, 70 peut être éliminée en une heure environ.

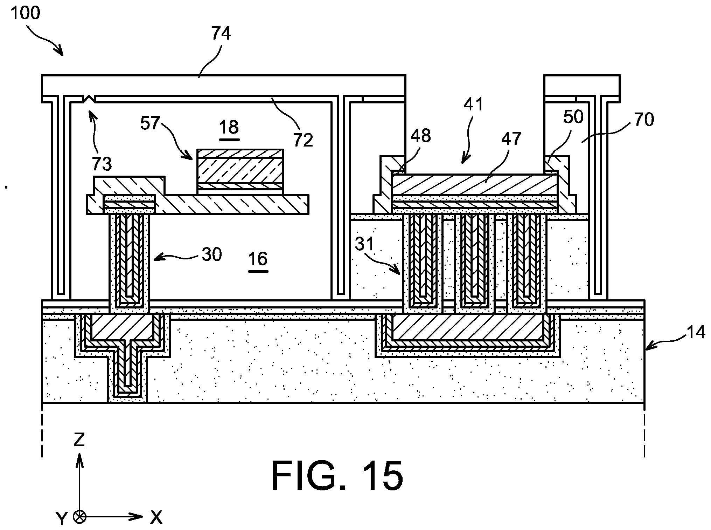

Comme représenté sur la figure 15, une couche de bouchage 74 transparente à l'infrarouge est déposée, remplissant d'une part une fonction de fermeture des orifices 73 pour obtenir des cavités fermées hermétiquement autour des détecteurs thermiques 57, 67 et d'autre part une fonction antireflet pour favoriser la transmission du rayonnement infrarouge à travers la couche d'encapsulation 72, en direction des détecteurs thermiques 57, 67. La couche de bouchage 74 comporte par exemple une alternance de dépôts de germanium et de sulfure de zinc, formant ainsi une couche antireflet de bonne qualité pour les longueurs d'ondes infrarouges comprises entre environ 8 µm et 12 µm. La couche de bouchage 74 peut être élaborée par une technique de dépôt de couches minces sous vide comme par exemple l'évaporation sous vide d'une source chauffée par faisceau d'électrons (EBPVD). On dispose donc à ce stade du procédé, de détecteurs thermiques de rayonnement infrarouge, enfermés à l'intérieur de cavités 18 fermées hermétiquement par des couches transparentes à l'infrarouge et sous pression atmosphérique réduite. Ces détecteurs thermiques 57, 67 sont donc fonctionnels en l'état sans qu'il soit nécessaire de les intégrer dans un boîtier sous vide. Il en résulte un coût de fabrication avantageux. Une dernière étape de photolithographie permet d'ouvrir les plots de connexion du dispositif de détection 100 formés par les deuxièmes contacts électriques 41 par un gravure localisée des couches 74, 72, 70, éventuellement des couches 48 et 50 si ces dernières ont été épargnées sur la surface des deuxièmes contacts électriques 41 à une étape précédente, pour déboucher sur la surface de la couche 47 de ces deuxièmes contacts électriques 41.

Le confinement, ou l'encapsulation, hermétique des détecteurs thermiques 57, 67 peut également être réalisé comme décrit par exemple dans le document US 5 895 233. Cette méthode de confinement est décrite ci-dessous en liaison avec le dispositif de détection 200 selon le deuxième mode de réalisation. Toutefois, un tel confinement peut être réalisé avec le dispositif de détection 100 selon le premier mode de réalisation.

Selon cette deuxième approche de confinement dans laquelle l'encapsulation est réalisée par report d'un deuxième substrat, on prévoit un deuxième substrat 90 choisi dans un matériau transparent à l'infrarouge, préférentiellement en silicium, qui est scellé avec le premier substrat 10 sur lequel sont formés les détecteurs thermiques 57, 67 reliés au circuit de lecture CMOS 12, le premier et le deuxième substrat étant espacés l'un de l'autre de manière à former une cavité hermétique autour des détecteurs thermiques.

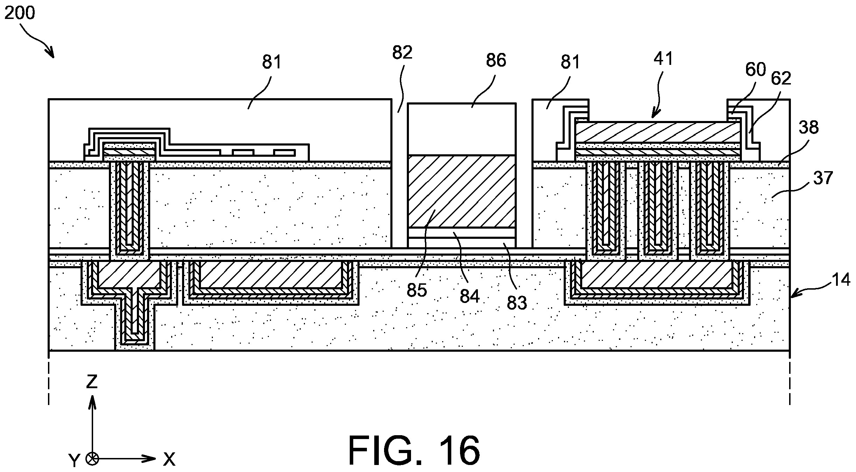

Ce confinement est mis en oeuvre à partir de la structure se trouvant dans l'état représenté sur la figure 7a dans lequel une étape de gravure des couches 60 et 62 définit et sépare les détecteurs thermiques les uns des autres et ouvre préférentiellement les couches 60, 62 sur la surface des deuxièmes contacts électriques 41. A ce stade de la réalisation, et comme représenté sur la figure 16, une couche diélectrique de protection 81, par exemple et préférentiellement de même nature que la couche sacrificielle 37 (en USG par exemple), est déposée puis planarisée. L'épaisseur de la couche diélectrique de protection 81 est typiquement comprise entre environ 0,5 µm et 2 µm. Une zone de tranchée 82, formant un périmètre fermé autour d'un ou plusieurs détecteurs thermiques destinés à être encapsulés, est définie par photolithographie, puis gravée à travers les couches 81, 38 et 37. On procède alors au dépôt d'une couche 83 utilisée comme couche d'accroche et comme barrière de diffusion au cuivre, puis au dépôt d'une couche 84 en cuivre qui sert à la fois de cathode et de couche de germination pour la croissance électrolytique d'une couche de cuivre 85 suivie d'une couche électrolytique d'étain 86. La couche 83 peut être prévue avec un alliage de titane et de tungstène (TiW), déposé par pulvérisation cathodique. L'étendue des couches 85, 86 est limitée à la surface des tranchées 82, par exemple en étendant une résine photosensible spécifiquement conçue pour localiser les réactions de croissance électrolytique, sur la surface du premier substrat déjà recouvert de la couche 84. La résine photosensible est ensuite ré-ouverte à l'aplomb de la tranchée 82 pour découvrir la couche de germination 84 où la croissance électrolytique peut se former. Des étapes de nettoyage permettent ensuite d'éliminer la résine photosensible et les couches métalliques 83, 84 de la surface plane de la couche 81 (nettoyage chimique et polissage mécano chimique).

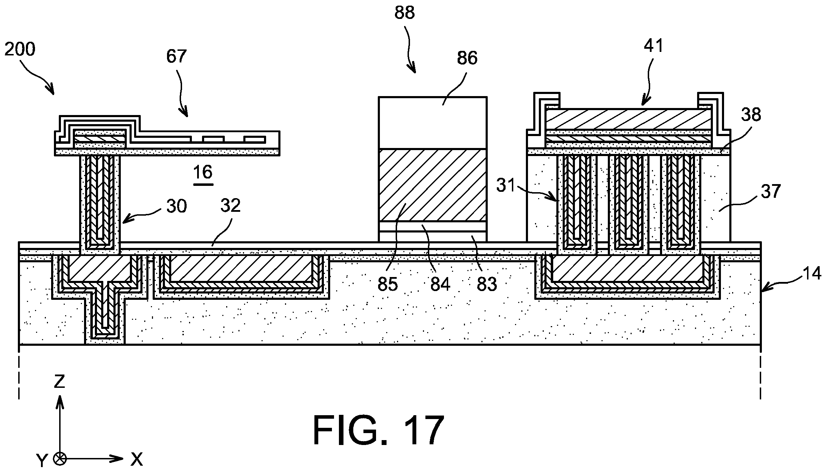

Au cours de l'étape suivante représentée sur la figure 17, les couches sacrificielles 37, 81 et la couche diélectrique 38 sont éliminées par attaque acide en milieu HF vapeur. La propagation verticale de l'attaque chimique est contrôlée par la présence de la couche d'arrêt de gravure 32 qui protège les couches IMD des niveaux d'interconnexions électriques inférieurs. La propagation de l'attaque chimique sous les plots de connexion est relativement peu étendue eu égard à leur dimension (de 100 µm à 150 µm de coté) très supérieure à l'épaisseur de la couche 37 (de 1 µm à 5 µm). Les couches 83, 84, 85, 86, respectivement en TiW, en cuivre, en cuivre électrolytique, en étain, résistent à l'acide fluorhydrique et restent donc en place.

Le premier substrat 10 comporte alors en surface des plots de connexions formés par les deuxièmes contacts électriques 41 et des membranes suspendues des détecteurs thermiques 67 entourées de cordons métalliques 88 prévus pour être scellés avec d'autres cordons métalliques 98 réalisés sur un deuxième substrat 90.

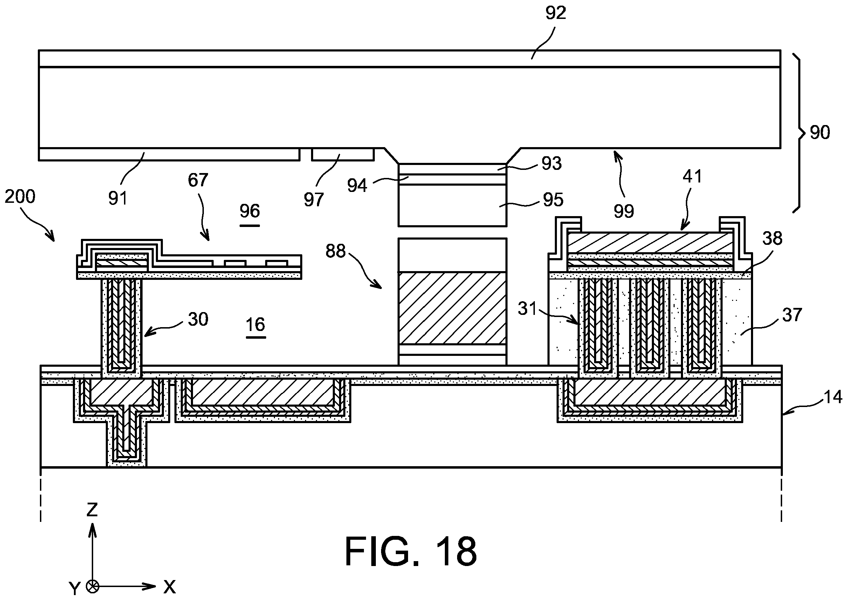

La figure 18 montre le deuxième substrat 90, préférentiellement en silicium, destiné à être solidarisé au premier substrat 10. Sur une première face du substrat 90 sont prévus :
- un cordon métallique 98 comportant un empilement de trois couches métalliques, constitué dans l'ordre depuis la surface du substrat 90, de TiW 93, de cuivre 94, de cuivre électrolytique 95, éventuellement d'étain électrolytique (non représenté), leur mode d'élaboration étant comparable à ceux déjà décrits pour le cordon métallique du premier substrat ;
- une couche antireflet 91 formée par exemple d'une alternance de couches de germanium et de sulfure de zinc ;
- une couche ou un ensemble de couches 97 ayant des propriétés de piégeage des molécules gazeuses (effet getter) prévues pour contrecarrer le dégazage des surfaces internes à la cavité hermétique 96 comprise entre les deux substrats après leur scellement. Des matériaux tels que le titane ou le zirconium, déposés par évaporation ou par pulvérisation cathodique sont privilégiés. L'étendue et l'emplacement du matériau getter 97 sont définis par des moyens classiques tels que le dépôt par lift-off, la photolithogravure ou le dépôt à travers un masque mécanique.

La première face du substrat 90 comporte de surcroît des enfoncements dans certains desquels sont formés les éléments 91, 97. Les cordons métalliques 98 sont quant à eux formés sur des zones du deuxième substrat 90 situées en dehors des enfoncements. Une deuxième couche antireflet 92, ou éventuellement un filtre optique plus sélectif, est en outre prévue sur la deuxième face du substrat 90.

On dispose ainsi d'un deuxième substrat 90 prêt à être scellé avec un premier substrat 10 et prévu de telle manière que l'on ait en vis-à-vis les cordons métalliques 98 et 88, le traitement antireflet 91 avec les membranes suspendues des détecteurs thermiques 57, 67, un enfoncement 99 en regard des deuxièmes contacts électriques 41. L'enfoncement 99 est prévu pour pouvoir découper à la scie la zone du substrat 90 en regard des deuxièmes contacts électriques 41, sans les endommager (étape non représentée).

L'opération de scellement des substrats 10 et 90 consiste alors à aligner les deux substrats de manière à mettre en contact leur cordon de scellement 88 et 98 l'un avec l'autre, puis à chauffer l'ensemble pour atteindre une température supérieure à la température de fusion de l'étain. Il en résulte l'inter-diffusion de l'étain dans le cuivre et la formation d'un alliage intermétallique cuivre-étain qui se solidifie avec un point de fusion sensiblement plus élevé que la température utilisée pour le scellement.

Avantageusement, cette opération de scellement est réalisée dans une chambre sous vide de manière à sceller hermétiquement sous vide les détecteurs thermiques 57, 67 dans des cavités hermétiques 96.

## Revendications

1. Dispositif de détection infrarouge (100, 200), comportant au moins :
- un circuit électronique de lecture (12) réalisé sur et/ou dans un premier substrat semi-conducteur (10), et sur lequel sont disposés plusieurs niveaux d'interconnexions électriques (14) tels qu'un premier niveau d'interconnexions électriques soit disposé entre le circuit électronique de lecture (12) et un dernier niveau d'interconnexions électriques ;
- une couche d'arrêt de gravure (32) disposée entre le dernier et un avant-dernier niveau d'interconnexions électriques et apte à résister à une gravure d'une première couche diélectrique inter-métal (37) disposée entre la couche d'arrêt de gravure (32) et le dernier niveau d'interconnexions électriques ;
- un détecteur thermique infrarouge (57, 67) relié électriquement au circuit électronique de lecture (12) par au moins un premier via électriquement conducteur (30) du dernier niveau d'interconnexions électriques qui traverse la couche d'arrêt de gravure (32) ;
- un plot de connexion (41) formé par le dernier niveau d'interconnexions électriques, relié électriquement au circuit électronique de lecture (12) par au moins un deuxième via électriquement conducteur (31) du dernier niveau d'interconnexions électriques qui traverse la couche d'arrêt de gravure (32), et apte à être contacté électriquement depuis l'extérieur du dispositif de détection infrarouge (100, 200) ;
dans lequel le détecteur thermique infrarouge (57, 67) et le plot de connexion (41) sont chacun espacés de la couche d'arrêt de gravure (32) d'une distance non nulle sensiblement égale l'une par rapport à l'autre, dans lequel le premier et le deuxième vias électriquement conducteurs (30, 31) sont respectivement reliés électriquement à des première et deuxième portions (21a, 21b) d'une ligne métallique (21) d'un avant-dernier niveau d'interconnexions électriques (20), et dans lequel un espace vide (16) formé dans la première couche diélectrique inter-métal (37) entoure le premier via électriquement conducteur (30) et s'étend sous le détecteur thermique infrarouge (57, 67),
et dans lequel, parmi le détecteur thermique infrarouge (57, 67) et le plot de connexion (41), seul le détecteur thermique infrarouge (57, 67) comporte au moins un élément absorbant (55, 65) apte à absorber un rayonnement infrarouge destiné à être détecté par le détecteur thermique infrarouge (57, 67) et au moins un élément thermométrique (56, 66) couplé à l'élément absorbant (55, 65),
et dans lequel le détecteur thermique infrarouge (57, 67) comporte une membrane suspendue se trouvant à ladite distance non nulle de la couche d'arrêt de gravure (32), la membrane suspendue comportant l'élément absorbant (55, 65) et l'élément thermométrique (56, 66).

2. Dispositif de détection infrarouge (100, 200) selon la revendication 1, dans lequel le circuit électronique de lecture (12) comporte une pluralité de dispositifs électroniques de type MOS réalisés sur et/ou dans le premier substrat semi-conducteur (10), dans lequel l'avant-dernier niveau d'interconnexions électriques (20) comporte des troisièmes vias électriquement conducteurs (22) réalisés dans une deuxième couche diélectrique inter-métal (27) et reliant électriquement au moins des premières portions (21a) de la ligne métallique (21) aux dispositifs électroniques de type MOS, et dans lequel la couche d'arrêt de gravure (32) est disposée sur la deuxième couche diélectrique inter-métal (27).

3. Dispositif de détection infrarouge (100, 200) selon la revendication 2, dans lequel la ligne métallique (21) et les troisièmes vias électriquement conducteurs (22) sont à base d'au moins un même matériau que celui du premier via électriquement conducteur (30).

4. Dispositif de détection infrarouge (100, 200) selon l'une des revendications précédentes, dans lequel au moins une troisième portion (69) de la ligne métallique (21) est disposée en regard du détecteur thermique infrarouge (57, 67) et est apte à réfléchir au moins une partie d'un rayonnement infrarouge destiné à être détecté par le détecteur thermique infrarouge (57, 67).

5. Dispositif de détection infrarouge (100, 200) selon la revendication 4, dans lequel la troisième portion (69) de la ligne métallique (21) n'est pas recouverte par la couche d'arrêt de gravure (32).

6. Dispositif de détection infrarouge (100) selon l'une des revendications précédentes, dans lequel le détecteur thermique infrarouge (57) comporte un empilement métal-isolant-métal (55) apte à absorber un rayonnement infrarouge destiné à être détecté par le détecteur thermique infrarouge (57), et au moins une portion de matériau (56), dont la résistivité varie en fonction de la température, couplée thermiquement avec l'empilement métal-isolant-métal (55) et reliée électriquement au premier via électriquement conducteur (30).

7. Dispositif de détection infrarouge (200) selon l'une des revendications 1 à 5, dans lequel le détecteur thermique infrarouge (67) comporte une pluralité de portions résistives (65) aptes à absorber un rayonnement infrarouge destiné à être détecté par le détecteur thermique infrarouge (67), et une pluralité de portions (66) de matériau dont la résistivité varie en fonction de la température, au moins une desdites portions (66) de matériau dont la résistivité varie en fonction de la température étant reliée électriquement au premier via électriquement conducteur (30).

8. Dispositif de détection infrarouge (100, 200) selon l'une des revendications précédentes, comportant en outre au moins un premier contact électrique (40) disposé sur le premier via électriquement conducteur (30), le détecteur thermique infrarouge (57, 67) étant relié électriquement au premier via électriquement conducteur (30) par l'intermédiaire dudit contact électrique (40).

9. Dispositif de détection infrarouge (100, 200) selon l'une des revendications précédentes, dans lequel le détecteur thermique infrarouge (57, 67) est encapsulé dans une cavité (18) délimitée au moins par une couche d'encapsulation (72), à base d'un matériau transparent à un rayonnement infrarouge destiné à être détecté par le détecteur thermique infrarouge (57, 67), et par la couche d'arrêt de gravure (32).

10. Dispositif de détection infrarouge (100, 200) selon l'une des revendications 1 à 8, dans lequel le détecteur thermique infrarouge (57, 67) est encapsulé dans une cavité (96) délimitée au moins par un deuxième substrat (90), la couche d'arrêt de gravure (32) et un cordon métallique (88) solidarisant le deuxième substrat (90) à la couche d'arrêt de gravure (32), le deuxième substrat (90) étant à base d'au moins un matériau transparent à un rayonnement infrarouge destiné à être détecté par le détecteur thermique infrarouge (57, 67).

11. Dispositif de détection infrarouge (100, 200) selon l'une des revendications précédentes, comportant une pluralité de détecteurs thermiques infrarouges (57, 67) formant une matrice de pixels du dispositif de détection infrarouge (100, 200), chaque détecteur thermique infrarouge (57, 67) étant relié électriquement au circuit électronique de lecture (12) par au moins un premier via électriquement conducteur (30).

12. Procédé de réalisation d'un dispositif de détection infrarouge (100, 200), comportant au moins la mise en oeuvre des étapes de :
- réalisation de plusieurs niveaux d'interconnexions électriques (14) sur un circuit électronique de lecture (12) réalisé sur et/ou dans un premier substrat semi-conducteur (10) et formant un empilement allant d'un premier niveau d'interconnexions électriques à un avant-dernier niveau d'interconnexions électriques ;
- dépôt d'une couche d'arrêt de gravure (32) sur l'avant-dernier niveau d'interconnexions électriques ;
- dépôt d'une première couche diélectrique inter-métal (37) sur la couche d'arrêt de gravure (32), la première couche diélectrique inter-métal (37) comprenant au moins un matériau minéral apte à être gravé sélectivement par rapport à la couche d'arrêt de gravure (32) ;
- réalisation, sur la première couche diélectrique inter-métal (37), d'un dernier niveau d'interconnexions électriques formant au moins un plot de connexion (41) relié électriquement au circuit électronique de lecture (12) par au moins un deuxième via électriquement conducteur (31) du dernier niveau d'interconnexions électriques qui traverse la première couche diélectrique inter-métal (37) et la couche d'arrêt de gravure (32), le plot de connexion (41) étant apte à être contacté électriquement depuis l'extérieur du dispositif de détection infrarouge (100, 200), et d'au moins un détecteur thermique infrarouge (57, 67) relié électriquement au circuit électronique de lecture (12) par au moins un premier via électriquement conducteur (30) du dernier niveau d'interconnexions électriques qui traverse la première couche diélectrique inter-métal (37) et la couche d'arrêt de gravure (32), le premier et le deuxième vias électriquement conducteurs (30, 31) étant respectivement reliés électriquement à des première et deuxième portions (21a, 21b) d'une ligne métallique (21) de l'avant-dernier niveau d'interconnexions électriques (20), et dans lequel le détecteur thermique infrarouge (57, 67) et le plot de connexion (41) sont chacun espacés de la couche d'arrêt de gravure (32) d'une distance non nulle sensiblement égale l'une par rapport à l'autre ;
- gravure d'au moins une partie de la première couche diélectrique inter-métal (37) disposée entre le circuit électronique de lecture (12) et le détecteur thermique infrarouge (57, 67), formant un espace vide (16) entourant le premier via électriquement conducteur (30) et s'étendant sous le détecteur thermique infrarouge (57, 67),
et dans lequel, parmi le détecteur thermique infrarouge (57, 67) et le plot de connexion (41), seul le détecteur thermique infrarouge (57, 67) comporte au moins un élément absorbant (55, 65) apte à absorber un rayonnement infrarouge destiné à être détecté par le détecteur thermique infrarouge (57, 67) et au moins un élément thermométrique (56, 66) couplé à l'élément absorbant (55, 65),
et dans lequel le détecteur thermique infrarouge (57, 67) comporte une membrane suspendue se trouvant à ladite distance non nulle de la couche d'arrêt de gravure (32), la membrane suspendue comportant l'élément absorbant (55, 65) et l'élément thermométrique (56, 66).

13. Procédé selon la revendication 12, dans lequel le circuit électronique de lecture (12) comporte une pluralité de dispositifs électroniques de type MOS réalisés sur et/ou dans le premier substrat semi-conducteur (10), et dans lequel l'avant-dernier niveau d'interconnexions électriques (20) comporte des troisièmes vias électriquement conducteurs (22) réalisés dans une deuxième couche diélectrique inter-métal (27) et reliant électriquement au moins des premières portions (21a) de la ligne métallique (21) aux dispositifs électroniques de type MOS, et dans lequel la couche d'arrêt de gravure (32) est déposée sur la deuxième couche diélectrique inter-métal (27).

14. Procédé selon la revendication 13, dans lequel la ligne métallique (21) et les troisièmes vias électriquement conducteurs (22) sont à base d'au moins un même matériau que celui du premier via électriquement conducteur (30), et dans lequel la deuxième couche diélectrique inter-métal (27) est à base d'un même matériau minéral que celui de la première couche diélectrique inter-métal (37).

15. Procédé selon l'une des revendications 12 à 14, dans lequel au moins une troisième portion (69) de la ligne métallique (21) est disposée en regard du détecteur thermique infrarouge (57, 67) et est apte à réfléchir au moins une partie d'un rayonnement infrarouge destiné à être détecté par le détecteur thermique infrarouge (57, 67).

16. Procédé selon la revendication 15, comportant en outre, entre l'étape de dépôt de la couche d'arrêt de gravure (32) et l'étape de dépôt de la première couche diélectrique inter-métal (37), une étape de gravure d'une partie de la couche d'arrêt de gravure (32) qui recouvre la troisième portion (69) de la ligne métallique (21).

17. Procédé selon l'une des revendications 12 à 16, dans lequel la réalisation du détecteur thermique infrarouge (57) comporte la réalisation d'un empilement métal-isolant-métal (55) apte à absorber un rayonnement infrarouge destiné à être détecté par le détecteur thermique infrarouge (57), et la réalisation d'au moins une portion de matériau (56), dont la résistivité varie en fonction de la température, couplée thermiquement avec l'empilement métal-isolant-métal (55) et reliée électriquement au premier via électriquement conducteur (30).

18. Procédé selon l'une des revendications 12 à 16, dans lequel la réalisation du détecteur thermique infrarouge (67) comporte la réalisation d'une pluralité de portions résistives (65) aptes à absorber un rayonnement infrarouge destiné à être détecté par le détecteur thermique infrarouge (67), et la réalisation d'une pluralité de portions (66) de matériau dont la résistivité varie en fonction de la température, au moins une desdites portions (66) de matériau dont la résistivité varie en fonction de la température étant reliée électriquement au premier via électriquement conducteur (30).

19. Procédé selon l'une des revendications 12 à 18, comportant en outre, entre l'étape de dépôt de la première couche diélectrique inter-métal (37) et l'étape de réalisation du détecteur thermique infrarouge (57, 67), la réalisation d'au moins un premier contact électrique (40) sur le premier via électriquement conducteur (30), le détecteur thermique infrarouge (57, 67) étant relié électriquement au premier via électriquement conducteur (30) par l'intermédiaire dudit contact électrique (40).

20. Procédé selon l'une des revendications 12 à 19, comportant en outre, entre l'étape de réalisation du détecteur thermique infrarouge (57, 67) et l'étape de gravure d'au moins une partie de la première couche diélectrique inter-métal (37), la mise en oeuvre des étapes de :
- dépôt d'une couche sacrificielle (70) recouvrant au moins le détecteur thermique infrarouge (57, 67), la couche sacrificielle (70) comprenant au moins un matériau minéral apte à être gravé sélectivement par rapport à la couche d'arrêt de gravure (32) ;
- gravure d'au moins une tranchée (71) à travers au moins la première couche diélectrique inter-métal (37) et la couche sacrificielle (70) et délimitant des portions de la première couche diélectrique inter-métal (37) et de la couche sacrificielle (70) ;
- dépôt dans ladite tranchée (71) et sur la portion de la couche sacrificielle (70), d'au moins une couche d'encapsulation (72) à base d'un matériau transparent à un rayonnement infrarouge destiné à être détecté par le détecteur thermique infrarouge (57, 67) ;
- réalisation d'au moins une ouverture (73) à travers la couche d'encapsulation (72) ;
dans lequel l'étape de gravure d'au moins une partie de la première couche diélectrique inter-métal (37) est réalisée via l'ouverture (73) et élimine lesdites portions de la première couche diélectrique inter-métal (37) et de la couche sacrificielle (70) telle que le détecteur thermique infrarouge (57, 67) soit encapsulé dans une cavité (18) délimitée au moins par la couche d'encapsulation (72) et la couche d'arrêt de gravure (32),
et comportant en outre, après ladite étape de gravure, la mise en oeuvre d'une étape de bouchage de l'ouverture (73).

21. Procédé selon l'une des revendications 12 à 19, comportant en outre, entre l'étape de réalisation du détecteur thermique infrarouge (57, 67) et l'étape de gravure d'au moins une partie de la première couche diélectrique inter-métal (37), la mise en oeuvre d'une étape de réalisation d'au moins un cordon métallique (88) sur la couche d'arrêt de gravure (32), à travers au moins la première couche diélectrique inter-métal (37), et comportant en outre, après l'étape de gravure d'au moins une partie de la première couche diélectrique inter-métal (37), la solidarisation d'au moins un deuxième substrat (90) au cordon métallique (88) telle que le détecteur thermique infrarouge (57, 67) soit encapsulé dans une cavité (96) délimitée au moins par le deuxième substrat (90), la couche d'arrêt de gravure (32) et le cordon métallique (88), le deuxième substrat (90) étant à base d'au moins un matériau transparent à un rayonnement infrarouge destiné à être détecté par le détecteur thermique infrarouge (57, 67).

22. Procédé selon l'une des revendications 12 à 21, comportant la réalisation d'une pluralité de détecteurs thermiques infrarouges (57, 67) formant une matrice de pixels du dispositif de détection infrarouge (100, 200), chaque détecteur thermique infrarouge (57, 67) étant relié électriquement au circuit électronique de lecture (12) par au moins un premier via électriquement conducteur (30).

## Patentansprüche

1. Infrarot-Detektionsvorrichtung (100, 200), mindestens enthaltend:
- eine elektronische Leseschaltung (12), die auf und/oder in einem ersten Halbleitersubstrat (10) ausgebildet ist, und auf der mehrere Ebenen elektrischer Vernetzungen (14) angeordnet sind, so dass eine erste Ebene elektrischer Vernetzungen zwischen der elektronischen Leseschaltung (12) und einer letzten Ebene elektrischer Vernetzungen angeordnet ist;
- eine Ätzsperrschicht (32), die zwischen der letzten und einer vorletzten Ebene elektrischer Vernetzungen angeordnet ist, und geeignet ist, einer Ätzung einer ersten intermetallischen dielektrischen Schicht (37), die zwischen der Ätzsperrschicht (32) und der letzten Ebene elektrischer Vernetzungen angeordnet ist, standzuhalten;
- einen Infrarot-Wärmedetektor (57, 67), der durch mindestens eine erste elektrisch leitende Via (30) der letzten Ebene elektrischer Vernetzungen, die durch die Ätzsperrschicht (32) verläuft, elektrisch an die elektronische Leseschaltung (12) angeschlossen ist;
- ein Anschluss-Pad (41), das aus der letzten Ebene elektrischer Vernetzungen gebildet ist, und durch mindestens eine zweite elektrisch leitende Via (31) der letzten Ebene elektrischer Vernetzungen, die durch die Ätzsperrschicht (32) verläuft, elektrisch an die elektronische Leseschaltung (12) angeschlossen ist, und geeignet ist, um von außerhalb der Infrarot-Detektionsvorrichtung (100, 200) elektrisch kontaktiert zu werden;
wobei der Infrarot-Wärmedetektor (57, 67) und das Anschluss-Pad (41) jeweils um einen im Wesentlichen gleichen Abstand ungleich null voneinander von der Ätzsperrschicht (32) beabstandet sind, wobei die erste und die zweite elektrisch leitende Via (30, 31) jeweils elektrisch an den ersten und zweiten Abschnitt (21a, 21b) einer Metallleitung (21) einer vorletzten Ebene elektrischer Vernetzungen (20) angeschlossen sind, und wobei ein Leerraum (16), der in der ersten intermetallischen dielektrischen Schicht (37) gebildet ist, die erste elektrisch leitende Via (30) umgibt, und sich unter dem Infrarot-Wärmedetektor (57, 67) erstreckt,
und wobei von dem Infrarot-Wärmedetektor (57, 67) und dem Anschluss-Pad (41) nur der Infrarot-Wärmedetektor (57, 67) mindestens ein absorbierendes Element (55, 65) enthält, das geeignet ist, eine Infrarotstrahlung zu absorbieren, die dazu bestimmt ist, durch den Infrarot-Wärmedetektor (57, 67) detektiert zu werden, und mindestens ein thermometrisches Element (56, 66), das mit dem absorbierenden Element (55, 65) gekoppelt ist,
und wobei der Infrarot-Wärmedetektor (57, 67) eine aufgehängte Membran enthält, die sich in dem Abstand ungleich null von der Ätzsperrschicht (32) befindet, wobei die aufgehängte Membran das absorbierende Element (55, 65) und das thermometrische Element (56, 66) enthält.

2. Infrarot-Detektionsvorrichtung (100, 200) nach Anspruch 1, wobei die elektronische Leseschaltung (12) eine Vielzahl von elektronischen Vorrichtungen vom Typ MOS enthält, die auf und/oder im ersten Halbleitersubstrat (10) ausgebildet sind, wobei die vorletzte Ebene elektrischer Vernetzungen (20) dritte elektrisch leitende Vias (22) enthält, die in einer zweiten intermetallischen dielektrischen Schicht (27) ausgebildet sind und mindestens erste Abschnitte (21a) der Metallleitung (21) elektrisch an die elektronischen Vorrichtungen vom Typ MOS anschließen, und wobei die Ätzsperrschicht (32) auf der zweiten intermetallischen dielektrischen Schicht (27) angeordnet ist.

3. Infrarot-Detektionsvorrichtung (100, 200) nach Anspruch 2, wobei die Metallleitung (21) und die dritten elektrisch leitenden Vias (22) auf mindestens demselben Material basieren wie das der ersten elektrisch leitenden Via (30).

4. Infrarot-Detektionsvorrichtung (100, 200) nach einem der vorhergehenden Ansprüche, wobei mindestens ein dritter Abschnitt (69) der Metallleitung (21) gegenüber dem Infrarot-Wärmedetektor (57, 67) angeordnet ist und geeignet ist, mindestens einen Teil einer Infrarotstrahlung zu reflektieren, die dazu bestimmt ist, vom Infrarot-Wärmedetektor (57, 67) detektiert zu werden.

5. Infrarot-Detektionsvorrichtung (100, 200) nach Anspruch 4, wobei der dritte Abschnitt (69) der Metallleitung (21) nicht von der Ätzsperrschicht (32) bedeckt ist.

6. Infrarot-Detektionsvorrichtung (100) nach einem der vorhergehenden Ansprüche, wobei der Infrarot-Wärmedetektor (57) einen Metall-Isolator-Metall-Stapel (55) enthält, der geeignet ist, eine Infrarotstrahlung zu absorbieren, die dazu bestimmt ist, vom Infrarot-Wärmedetektor (57) detektiert zu werden, und mindestens einen Abschnitt des Materials (56), dessen Resistivität sich in Abhängigkeit von der Temperatur ändert, und thermisch mit dem Metall-Isolator-Metall-Stapel (55) gekoppelt ist und elektrisch an die erste elektrisch leitende Via (30) angeschlossen ist.

7. Infrarot-Detektionsvorrichtung (200) nach einem der Ansprüche 1 bis 5, wobei der Infrarot-Wärmedetektor (67) eine Vielzahl von Resistivitätsabschnitten (65) enthält, die geeignet sind, eine Infrarotstrahlung zu absorbieren, die dazu bestimmt ist, durch den Infrarot-Wärmedetektor (67) detektiert zu werden, und eine Vielzahl von Abschnitten (66) des Material, dessen Resistivität sich in Abhängigkeit von der Temperatur ändert, wobei mindestens einer der Abschnitte (66) des Materials, dessen Resistivität sich in Abhängigkeit von der Temperatur ändert, elektrisch an die erste elektrisch leitende Via (30) angeschlossen ist.

8. Infrarot-Detektionsvorrichtung (100, 200) nach einem der vorhergehenden Ansprüche, ferner mindestens einen ersten elektrischen Kontakt (40) enthaltend, der auf der ersten elektrisch leitenden Via (30) angeordnet ist, wobei der Infrarot-Wärmedetektor (57, 67) über den elektrischen Kontakt (40) elektrisch an die erste elektrisch leitende Via (30) angeschlossen ist.

9. Infrarot-Detektionsvorrichtung (100, 200) nach einem der vorhergehenden Ansprüche, wobei der Infrarot-Wärmedetektor (57, 67) in einem Hohlraum (18) eingekapselt ist, der mindestens durch eine Verkapselungsschicht (72) begrenzt ist, die auf einem Material basiert, das für eine Infrarotstrahlung transparent ist, die dafür bestimmt ist, durch den Infrarot-Wärmedetektor (57, 67) detektiert zu werden, und durch die Ätzsperrschicht (32).

10. Infrarot-Detektionsvorrichtung (100, 200) nach einem der Ansprüche 1 bis 8, wobei der Infrarot-Wärmedetektor (57, 67) in einem Hohlraum (96) eingekapselt ist, der mindestens begrenzt ist durch ein zweites Substrat (90), die Ätzsperrschicht (32) und ein Metallband (88), das das zweite Substrat (90) mit der Ätzsperrschicht (32) fest verbindet, wobei das zweite Substrat (90) auf mindestens einem Material basiert, das für eine Infrarotstrahlung transparent ist, die dazu bestimmt ist, durch den Infrarot-Wärmedetektor (57, 67) detektiert zu werden.

11. Infrarot-Detektionsvorrichtung (100, 200) nach einem der vorhergehenden Ansprüche, eine Vielzahl von Infrarot-Wärmedetektoren (57, 67) enthaltend, die eine Matrix der Pixel der Infrarot-Detektionsvorrichtung (100, 200) bilden, wobei jeder Infrarot-Wärmedetektor (57, 67) durch mindestens eine erste elektrisch leitende Via (30) elektrisch an die elektronische Leseschaltung (12) angeschlossen ist.

12. Verfahren zur Bildung einer Infrarot-Detektionsvorrichtung (100, 200), mindestens die Durchführung der Schritte enthaltend:
- Bildung mehrerer Ebenen elektrischer Vernetzungen (14) auf einer elektronischen Leseschaltung (12), die auf und/oder in einem ersten Halbleitersubstrat (10) ausgebildet ist und einen Stapel bildet, der von einer ersten Ebene elektrischer Vernetzungen zu einer vorletzten Ebene elektrischer Vernetzungen reicht;
- Abscheidung einer Ätzsperrschicht (32) auf der vorletzten Ebene elektrischer Vernetzungen;
- Abscheidung einer ersten intermetallischen dielektrischen Schicht (37) auf der Ätzsperrschicht (32), wobei die erste intermetallische dielektrische Schicht (37) mindestens ein mineralisches Material enthält, das geeignet ist, selektiv in Bezug auf die Ätzsperrschicht (32) geätzt zu werden;
- Bildung, auf der ersten intermetallischen dielektrische Schicht (37), einer letzten Ebene elektrischer Vernetzungen, die mindestens ein Anschluss-Pad (41) bildet, das durch mindestens eine zweite elektrisch leitende Via (31) der letzten Ebene von elektrischen Vernetzungen, die durch die erste intermetallische dielektrische Schicht (37) und die Ätzsperrschicht (32) verläuft, elektrisch an die elektronische Leseschaltung (12) angeschlossen ist, wobei das Anschluss-Pad (41) geeignet ist, von außerhalb der Infrarot-Detektionsvorrichtung (100, 200) elektrisch kontaktiert zu werden, und von mindestens einem Infrarot-Wärmedetektor (57, 67), der durch mindestens eine erste elektrisch leitende Via (30) der letzten Ebene elektrischer Vernetzungen, die durch die erste intermetallische dielektrische Schicht (37) und die Ätzsperrschicht (32) verläuft, elektrisch an die elektronische Leseschaltung (12) angeschlossen ist, wobei die erste und die zweite elektrisch leitende Via (30, 31) jeweils elektrisch an die ersten und zweiten Abschnitte (21a, 21b) einer Metallleitung (21) der vorletzten Ebene elektrischer Vernetzungen (20) angeschlossen sind, und wobei der Infrarot-Wärmedetektor (57, 67) und das Anschluss-Pad (41) jeweils um einen im Wesentlichen gleichen Abstand ungleich null voneinander von der Ätzsperrschicht (32) beabstandet sind;
- Ätzung mindestens eines Teils der ersten intermetallischen dielektrischen Schicht (37), die zwischen der elektronischen Leseschaltung (12) und dem Infrarot-Wärmedetektor (57, 67) angeordnet ist und einen Leerraum (16) bildet, der die erste elektrisch leitende Via (30) umgibt und sich unter dem Infrarot-Wärmedetektor (57, 67) erstreckt,
und wobei unter dem Infrarot-Wärmedetektor (57, 67) und dem Anschluss-Pad (41) nur der Infrarot-Wärmedetektor (57, 67) mindestens ein absorbierendes Element (55, 65) enthält, das geeignet ist, eine Infrarotstrahlung zu absorbieren, die dazu bestimmt ist, vom Infrarot-Wärmedetektor (57, 67) detektiert zu werden, und mindestens ein thermometrisches Element (56, 66), das mit dem absorbierenden Element (55, 65) gekoppelt ist,
und wobei der Infrarot-Wärmedetektor (57, 67) eine aufgehängte Membran enthält, die sich in dem Abstand ungleich null von der Ätzsperrschicht (32) befindet, wobei die aufgehängte Membran das absorbierende Element (55, 65) und das thermometrische Element (56, 66) enthält.

13. Verfahren nach Anspruch 12, wobei die elektronische Leseschaltung (12) eine Vielzahl von elektronischen Vorrichtungen vom Typ MOS enthält, die auf und/oder im ersten Halbleitersubstrat (10) ausgebildet sind, und wobei die vorletzte Ebene elektrischer Vernetzungen (20) dritte elektrisch leitende Vias (22) enthält, die in einer zweiten intermetallischen dielektrischen Schicht (27) ausgebildet sind und mindestens erste Abschnitte (21a) der Metallleitung (21) elektrisch an die elektronischen Vorrichtungen vom Typ MOS anschließen, und wobei die Ätzsperrschicht (32) auf der zweiten intermetallischen dielektrischen Schicht (27) abgeschieden ist.

14. Verfahren nach Anspruch 13, wobei die Metallleitung (21) und die dritten elektrisch leitenden Vias (22) auf mindestens demselben Material wie das der ersten elektrisch leitenden Via (30) basieren, und wobei die zweite intermetallische dielektrische Schicht (27) auf demselben mineralischen Material wie das der ersten intermetallischen dielektrischen Schicht (37) basiert.

15. Verfahren nach einem der Ansprüche 12 bis 14, wobei mindestens ein dritter Abschnitt (69) der Metallleitung (21) gegenüber dem Infrarot-Wärmedetektor (57, 67) angeordnet ist und geeignet ist, mindestens einen Teil einer Infrarotstrahlung zu reflektieren, die dazu bestimmt ist, vom Infrarot-Wärmedetektor (57, 67) detektiert zu werden.

16. Verfahren nach Anspruch 15, ferner zwischen dem Schritt der Abscheidung der Ätzsperrschicht (32) und dem Schritt der Abscheidung der ersten intermetallischen dielektrischen Schicht (37) einen Schritt der Ätzung eines Teils der Ätzsperrschicht (32) enthaltend, der den dritten Abschnitt (69) der Metallleitung (21) bedeckt.

17. Verfahren nach einem der Ansprüche 12 bis 16, wobei die Bildung des Infrarot-Wärmedetektors (57) die Bildung eines Metall-Isolator-Metall-Stapels (55) enthält, der geeignet ist, eine Infrarotstrahlung zu absorbieren, die dazu bestimmt ist, vom Infrarot-Wärmedetektor (57) detektiert zu werden, und die Bildung von mindestens einem Abschnitt des Materials (56), dessen Resistivität sich in Abhängigkeit von der Temperatur ändert, und thermisch mit dem Metall-Isolator-Metall-Stapel (55) gekoppelt ist und elektrisch an die erste elektrisch leitende Via (30) angeschlossen ist.

18. Verfahren nach einem der Ansprüche 12 bis 16, wobei die Bildung des Infrarot-Wärmedetektors (67) die Bildung einer Vielzahl von Resistivitätsabschnitten (65) enthält, die geeignet sind, eine Infrarotstrahlung zu absorbieren, die dazu bestimmt ist, vom Infrarot-Wärmedetektor (67) detektiert zu werden, und die Bildung einer Vielzahl von Abschnitten (66) von Material, dessen Resistivität sich in Abhängigkeit von der Temperatur ändert, wobei mindestens einer der Abschnitte (66) von Material, dessen Resistivität sich in Abhängigkeit von der Temperatur ändert, elektrisch an die erste elektrisch leitende Via (30) angeschlossen ist.

19. Verfahren nach einem der Ansprüche 12 bis 18, ferner zwischen dem Schritt der Abscheidung der ersten intermetallischen dielektrischen Schicht (37) und dem Schritt der Bildung des Infrarot-Wärmedetektors (57, 67) die Bildung von mindestens einem ersten elektrischen Kontakt (40) auf der ersten elektrisch leitenden Via (30) enthaltend, wobei der Infrarot-Wärmedetektor (57, 67) über den elektrischen Kontakt (40) elektrisch an die erste elektrisch leitende Via (30) angeschlossen ist.

20. Verfahren nach einem der Ansprüche 12 bis 19, ferner zwischen dem Schritt der Bildung des Infrarot-Wärmedetektors (57, 67) und dem Schritt der Ätzung mindestens eines Teils der ersten intermetallischen dielektrischen Schicht (37) die Durchführung der Schritte enthaltend:
- Abscheidung einer Opferschicht (70), die mindestens den Infrarot-Wärmedetektor (57, 67) bedeckt, wobei die Opferschicht (70) mindestens ein mineralisches Material enthält, das geeignet ist, selektiv in Bezug auf die Ätzsperrschicht (32) geätzt zu werden;
- Ätzung mindestens einer Schneise (71) durch mindestens die erste intermetallische dielektrische Schicht (37) und die Opferschicht (70) hindurch, und die Abschnitte der ersten intermetallischen dielektrischen Schicht (37) und der Opferschicht (70) begrenzend;
- Abscheidung, in der Schneise (71) und auf dem Abschnitt der Opferschicht (70), von mindestens einer Verkapselungsschicht (72), die auf einem Material basiert, das transparent ist für eine Infrarotstrahlung, die dazu bestimmt ist, durch den Infrarot-Wärmedetektor (57, 67) detektiert zu werden;
- Bildung von mindestens einer Öffnung (73) durch die Verkapselungsschicht (72) hindurch;
wobei der Schritt der Ätzung mindestens eines Teils der ersten intermetallischen dielektrischen Schicht (37) über die Öffnung (73) erfolgt und die Abschnitte der ersten intermetallischen dielektrischen Schicht (37) und der Opferschicht (70) entfernt, so dass der Infrarot-Wärmedetektor (57, 67) in einem Hohlraum (18) eingekapselt ist, der mindestens durch die Verkapselungsschicht (72) und die Ätzsperrschicht (32) begrenzt ist,
und ferner, nach dem Ätzschritt, die Durchführung eines Schritts der Verschließung der Öffnung (73) enthält.

21. Verfahren nach einem der Ansprüche 12 bis 19, ferner zwischen dem Schritt der Bildung des Infrarot-Wärmedetektors (57, 67) und dem Schritt der Ätzung von mindestens einem Teil der ersten intermetallischen dielektrischen Schicht (37) die Durchführung eines Schritts zur Bildung von mindestens einem Metallband (88) auf der Ätzsperrschicht (32) durch mindestens die erste intermetallische dielektrische Schicht (37) hindurch enthaltend, und ferner, nach dem Schritt der Ätzung von mindestens einem Teil der ersten intermetallischen dielektrischen Schicht (37), das feste Verbinden mindestens eines zweiten Substrat (90) mit dem Metallband (88) enthaltend, so dass der Infrarot-Wärmedetektor (57, 67) in einem Hohlraum (96) eingekapselt ist, der mindestens durch das zweite Substrat (90), die Ätzsperrschicht (32) und das Metallband (88) begrenzt ist, wobei das zweite Substrat (90) auf mindestens einem Material basiert, das für eine Infrarotstrahlung transparent ist, die dazu bestimmt ist, durch den Infrarot-Wärmedetektor (57, 67) detektiert zu werden.

22. Verfahren nach einem der Ansprüche 12 bis 21, die Bildung einer Vielzahl von Infrarot-Wärmedetektoren (57, 67) enthaltend, die eine Matrix von Pixeln der Infrarot-Detektionsvorrichtung (100, 200) bilden, wobei jeder Infrarot-Wärmedetektor (57, 67) durch mindestens eine erste elektrisch leitende Via (30) elektrisch an die elektronische Leseschaltung (12) angeschlossen ist.

## Claims

1. An infrared detection device (100, 200), including at least:
- an electronic readout circuit (12) made over and/or in a first semiconductor substrate (10), and over which several electrical interconnection levels (14) are arranged such that a first electrical interconnection level is arranged between the electronic readout circuit (12) and a last electrical interconnection level;
- an etching stop layer (32) arranged between the last and a penultimate electrical interconnection level (20) and able to withstand etching of a first inter-metal dielectric layer (37) arranged between the etching stop layer (32) and the last electrical interconnection level;
- an infrared thermal detector (57, 67) electrically connected to the electronic readout circuit (12) by at least one first electrically-conductive via (30) of the last electrical interconnection level which crosses the etching stop layer (32);
- a connection pad (41) formed by the last electrical interconnection level, electrically connected to the electronic readout circuit (12) by at least one second electrically-conductive via (31) of the last electrical interconnection level which crosses the etching stop layer (32), and able to be electrically contacted from outside the infrared detection device (100, 200);
wherein each of the infrared thermal detector (57, 67) and the connection pad (41) is spaced apart from the etching stop layer (32) by a non-zero distance substantially equal to each other, wherein the first and second electrically-conductive vias (30, 31) are respectively electrically connected to first and second portions (21a, 21b) of a metal line (21) of a penultimate electrical interconnection level (20), and wherein an empty space (16) formed in the first inter-metal dielectric layer (37) surrounds the first electrically-conductive via (30) and extends under the infrared thermal detector (57, 67),
and wherein, amongst the infrared thermal detector (57, 67) and the connection pad (41), only the infrared thermal detector (57, 67) includes at least one absorbent element (55, 65) able to absorb an infrared radiation intended to be detected by the infrared thermal detector (57, 67) and at least one thermometric element (56, 66) coupled to the absorbent element (55, 65),
and wherein the infrared thermal detector (57, 67) includes a suspended membrane located at said non-zero distance from the etching stop layer (32), the suspended membrane including the absorbent element (55, 65) and the thermometric element (56, 66).

2. The infrared detection device (100, 200) according to claim 1, wherein the electronic readout circuit (12) includes a plurality of MOS-type electronic devices made over and/or in the first semiconductor substrate (10), wherein the penultimate electrical interconnection level (20) includes third electrically-conductive vias (22) made in a second inter-metal dielectric layer (27) and electrically connecting at least first portions (21a) of the metal line (21) to the MOS-type electronic devices, and wherein the etching stop layer (32) is arranged over the second inter-metal dielectric layer (27).

3. The infrared detection device (100, 200) according to claim 2, wherein the metal line (21) and the third electrically-conductive vias (22) are made based on at least one material similar to that one of the first electrically-conductive via (30).

4. The infrared detection device (100, 200) according to one of the preceding claims, wherein at least one third portion (69) of the metal line (21) is arranged opposite the infrared thermal detector (57, 67) and is able to reflect at least one portion of an infrared radiation intended to be detected by the infrared thermal detector (57, 67).

5. The infrared detection device (100, 200) according to claim 4, wherein the third portion (69) of the metal line (21) is not covered by the etching stop layer (32).

6. The infrared detection device (100) according to one of the preceding claims, wherein the infrared thermal detector (57) includes a metal-insulator-metal stack (55) able to absorb infrared radiation intended to be detected by the infrared thermal detector (57), and at least one material portion (56), whose resistivity varies according to temperature, thermally coupled with the metal-insulator-metal stack (55) and electrically connected to the first electrically-conductive via (30).

7. The infrared detection device (200) according to one of claims 1 to 5, wherein the infrared thermal detector (67) includes a plurality of resistive portions (65) able to absorb an infrared radiation intended to be detected by the infrared thermal detector (67), and a plurality of material portions (66) the resistivity of which varies according to temperature, at least one of said material portions (66) whose resistivity varies according to temperature being electrically connected to the first electrically-conductive via (30).

8. The infrared detection device (100, 200) according to one of the preceding claims, further including at least one first electrical contact (40) arranged over the first electrically-conductive via (30), the infrared thermal detector (57, 67) being electrically connected to the first electrically-conductive via (30) via said electrical contact (40).

9. The infrared detection device (100, 200) according to one of the preceding claims, wherein the infrared thermal detector (57, 67) is encapsulated in a cavity (18) delimited at least by an encapsulation layer (72) made based on a material transparent to an infrared radiation intended to be detected by the infrared thermal detector (57, 67), and by the etching stop layer (32).

10. The infrared detection device (100, 200) according to one of claims 1 to 8, wherein the infrared thermal detector (57, 67) is encapsulated in a cavity (96) delimited at least by a second substrate (90), the etching stop layer (32) and a metal bead (88) securing the second substrate (90) to the etching stop layer (32), the second substrate (90) being made based on at least one material transparent to an infrared radiation intended to be detected by the infrared thermal detector (57, 67).

11. The infrared detection device (100, 200) according to one of the preceding claims, including a plurality of infrared thermal detectors (57, 67) forming an array of pixels of the infrared detection device (100, 200), each infrared thermal detector (57, 67) being electrically connected to the electronic readout circuit (12) through at least one first electrically-conductive via (30).

12. A method for making an infrared detection device (100, 200), including at least the implementation of the steps of:
- making several electrical interconnection levels (14) on an electronic readout circuit (12) made over and/or in a first semiconductor substrate (10) and forming a stack from a first electrical interconnection level to a penultimate electrical interconnection level (20);
- depositing an etching stop layer (32) over the penultimate electrical interconnection level (20);
- depositing a first inter-metal dielectric layer (37) over the etching stop layer (32), the first inter-metal dielectric layer (37) comprising at least one mineral material able to be selectively etched with respect to the etching stop layer (32);
- making, on the first inter-metal dielectric layer (37), a last electrical interconnection level forming at least one connection pad (41) electrically connected to the electronic readout circuit (12) through at least one second electrically-conductive via (31) of the last electrical interconnection level which crosses the first inter-metal dielectric layer (37) and the etching stop layer (32), the connection pad (41) being able to be electrically contacted from outside the infrared detection device (100, 200), and at least one infrared thermal detector (57, 67) electrically connected to the electronic readout circuit (12) through at least one first electrically-conductive via (30) of the last electrical interconnection level which crosses the first inter-metal dielectric layer (37) and the etching stop layer (32), the first and second electrically-conductive vias (30, 31) being respectively electrically connected to first and second portions (21a, 21b) of a metal line (21) of the penultimate electrical interconnection level (20), and wherein each of the infrared thermal detector (57, 67) and the connection pad (41) is spaced apart from the etching stop layer (32) by a non-zero distance substantially equal to each other;
- etching at least one portion of the first inter-metal dielectric layer (37) arranged between the electronic readout circuit (12) and the infrared thermal detector (57, 67), forming an empty space (16) surrounding the first electrically-conductive via (30) and extending under the infrared thermal detector (57, 67),
and wherein, amongst the infrared thermal detector (57, 67) and the connection pad (41), only the infrared thermal detector (57, 67) includes at least one absorbent element (55, 65) able to absorb an infrared radiation intended to be detected by the infrared thermal detector (57, 67) and at least one thermometric element (56, 66) coupled to the absorbent element (55, 65),
and wherein the infrared thermal detector (57, 67) includes a suspended membrane located at said non-zero distance from the etching stop layer (32), the suspended membrane including the absorbent element (55, 65) and the thermometric element (56, 66).

13. The method according to claim 12, wherein the electronic readout circuit (12) includes a plurality of MOS-type electronic devices made over and/or in the first semiconductor substrate (10), and wherein the penultimate electrical interconnection level (20) includes third electrically-conductive vias (22) made in a second inter-metal dielectric layer (27) and electrically connecting at least first portions (21a) of the metal line (21) to the MOS-type electronic devices, and wherein the etching stop layer (32) is deposited over the second inter-metal dielectric layer (27).

14. The method according to claim 13, wherein the metal line (21) and the third electrically-conductive vias (22) are made based on at least one material similar to that one of the first electrically-conductive via (30), and wherein the second inter-metal dielectric layer (27) is made based on a mineral material similar to that one of the first inter-metal dielectric layer (37).

15. The method according to one of claims 12 to 14, wherein at least one third portion (69) of the metal line (21) is arranged opposite the infrared thermal detector (57, 67) and is able to reflect at least one portion of an infrared radiation intended to be detected by the infrared thermal detector (57, 67).

16. The method according to claim 15, further including, between the step for depositing the etching stop layer (32) and the step for depositing the first inter-metal dielectric layer (37), a step of etching a portion of the etching stop layer (32) which covers the third portion (69) of the metal line (21).

17. The method according to one of claims 12 to 16, wherein making of the infrared thermal detector (57) includes making a metal-insulator-metal stack (55) able to absorb an infrared radiation intended to be detected by the infrared thermal detector (57), and making of at least one material portion (56), whose resistivity varies according to temperature, thermally coupled with the metal-insulator-metal stack (55) and electrically connected to the first electrically-conductive via (30).

18. The method according to one of claims 12 to 16, wherein making of the infrared thermal detector (67) includes making a plurality of resistive portions (65) able to absorb an infrared radiation intended to be detected by the infrared thermal detector (67), and making of a plurality of material portions (66) whose resistivity varies according to temperature, at least one of said material portions (66) whose resistivity varies according to temperature, being electrically connected to the first electrically-conductive via (30).

19. The method according to one of claims 12 to 18, further including, between the step of depositing the first inter-metal dielectric layer (37) and the step of making the infrared thermal detector (57, 67), making at least one first electrical contact (40) over the first electrically-conductive via (30), the infrared thermal detector (57, 67) being electrically connected to the first electrically-conductive via (30) via said electrical contact (40).

20. The method according to one of claims 12 to 19, further including, between the step of making the infrared thermal detector (57, 67) and the step of etching at least one portion of the first inter-metal dielectric layer (37), the implementation of the steps of:
- depositing a sacrificial layer (70) covering at least the infrared thermal detector (57, 67), the sacrificial layer (70) comprising at least one mineral material able to be selectively etched with respect to the etching stop layer (32);
- etching at least one trench (71) through at least the first inter-metal dielectric layer (37) and the sacrificial layer (70) and delimiting portions of the first inter-metal dielectric layer (37) and of the sacrificial layer (70);
- depositing in said trench (71) and over the portion of the sacrificial layer (70), at least one encapsulation layer (72) made based on a material transparent to an infrared radiation intended to be detected by the infrared thermal detector (57, 67);
- making at least one aperture (73) through the encapsulation layer (72);
wherein the step of etching at least one portion of the first inter-metal dielectric layer (37) is carried out via the aperture (73) and eliminates said portions of the first inter-metal dielectric layer (37) and of the sacrificial layer (70) such that the infrared thermal detector (57, 67) is encapsulated in a cavity (18) delimited at least by the encapsulation layer (72) and the etching stop layer (32),
and further including, after said etching step, the implementation of a step for plugging the aperture (73).

21. The method according to one of claims 12 to 19, further including, between the step of making the infrared thermal detector (57, 67) and the step of etching at least one portion of the first inter-metal dielectric layer (37), the implementation of a step of making at least one metal bead (88) over the etching stop layer (32), through at least the first inter-metal dielectric layer (37), and further including, after the step of etching at least one portion of the first inter-metal dielectric layer (37), securing at least one second substrate (90) to the metal bead (88) such that the infrared thermal detector (57, 67) is encapsulated in a cavity (96) delimited at least by the second substrate (90), the etching stop layer (32) and the metal bead (88), the second substrate (90) being made based on at least one material transparent to an infrared radiation intended to be detected by the infrared thermal detector (57, 67).

22. The method according to one of claims 12 to 21, including making a plurality of infrared thermal detectors (57, 67) forming an array of pixels of the infrared detection device (100, 200), each infrared thermal detector (57, 67) being electrically connected to the electronic readout circuit (12) through at least one first electrically-conductive via (30).
